# EUROPEAN PATENT APPLICATION

(11) **EP 4 596 641 A1**
(43) Date of publication of application: **06.08.2025**
(21) Application number: 25153022.6
(22) Date of filing: 21.01.2025
(51) Int. Cl.: C09D 11/38, C09D 11/52, C09K 11/06, H10K 50/15, H10K 50/16, H10K 50/17, H10K 71/13

(54) **INK COMPOSITION, LIGHT-EMITTING ELEMENT, AND METHOD FOR MANUFACTURING THE LIGHT-EMITTING ELEMENT**

(30) Priority: 29.01.2024 KR 20240013037
(71) Applicant: Samsung Display Co., Ltd., Gyeonggi-Do (KR)
(72) Inventor: PARK, Chul Soon, Yongin-si (KR); PARK, Won-Jun, Yongin-si (KR)
(74) Representative: Marks & Clerk LLP

(57) **Abstract**

Embodiments provide an ink composition, a light-emitting element produced from the ink composition, and a method for manufacturing the light-emitting element. The ink composition includes a metal oxide and an additive, wherein the ink composition has a viscosity in a range of about 7.5 cp to about 8.0 cp at a temperature of about 25 °C. The additive is represented by Chemical Formula 1, which is explained in the specification.

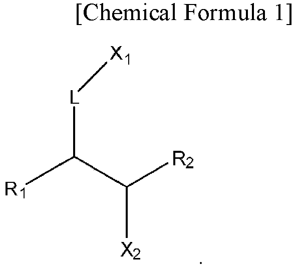

## Description

### BACKGROUND

### 1. Technical Field

The disclosure relates to an ink composition having a viscosity in a specific range, a light-emitting element with improved luminous efficiency and element lifespan, and a method for manufacturing the light-emitting element.

### 2. Description of the Related Art

A light-emitting element converts electrical energy into light energy. Among light-emitting elements, a quantum dot light-emitting element, which includes quantum dots in a light-emitting layer, has high color purity and high light-emitting efficiency and can display multiple colors. In a light-emitting element, holes move to the light-emitting layer via a hole transport region, and electrons move to the light-emitting layer via an electron transport region. Current research is directed to efficient injection and transport of electrons in order to improve emission efficiency in a quantum dot light-emitting element.

A material for an electron transport region with excellent electron transport property and stability is being developed so as to realize a light-emitting element with high luminous efficiency and a long lifespan.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides an ink composition that is capable of improving luminous characteristics and element lifespan of a light-emitting element.

The disclosure also provides a light-emitting element with improved luminous efficiency and element lifespan.

The disclosure also provides a method for manufacturing a light-emitting element with improved luminous efficiency and element lifespan.

According to embodiment, an ink composition includes a metal oxide, and an additive represented by Chemical Formula 1, wherein the ink composition has a viscosity in a range of about 7.5 cP to about 8.0 cP at a temperature of about 25 °C.

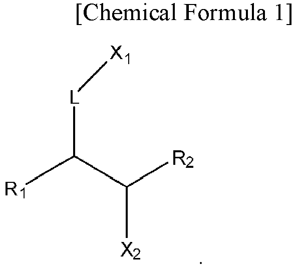

In Chemical Formula 1, X₁ and X₂ are each independently a hydroxy group, a substituted or unsubstituted amine group, or a cyano group; L is a direct linkage or substituted or unsubstituted methylene group; and Ri and R₂ are each independently a hydrogen atom, or a substituted or unsubstituted alkyl group having 1 to 8 carbon atoms (e.g. 1 to 6 carbon atoms).

In an embodiment, in Chemical Formula 1, Ri may be an unsubstituted methyl group, an unsubstituted ethyl group, an unsubstituted n-propyl group, an unsubstituted n-butyl group, an unsubstituted n-pentyl group, or an unsubstituted n-hexyl group.

In an embodiment, in Chemical Formula 1, R₂ may be an unsubstituted methyl group, an unsubstituted ethyl group, or an unsubstituted n-propyl group.

In an embodiment, in Chemical Formula 1, L may be an unsubstituted methylene group.

In an embodiment, a volumetric amount of the additive may be in a range of about 7% to about 10% of a total volume of the ink composition.

In an embodiment, the ink composition may further include a solvent that disperses the metal oxide and the additive.

In an embodiment, the ink composition may further include an organic ligand surrounding the metal oxide.

In an embodiment, the additive may include at least one compound selected from Compound Group 1.

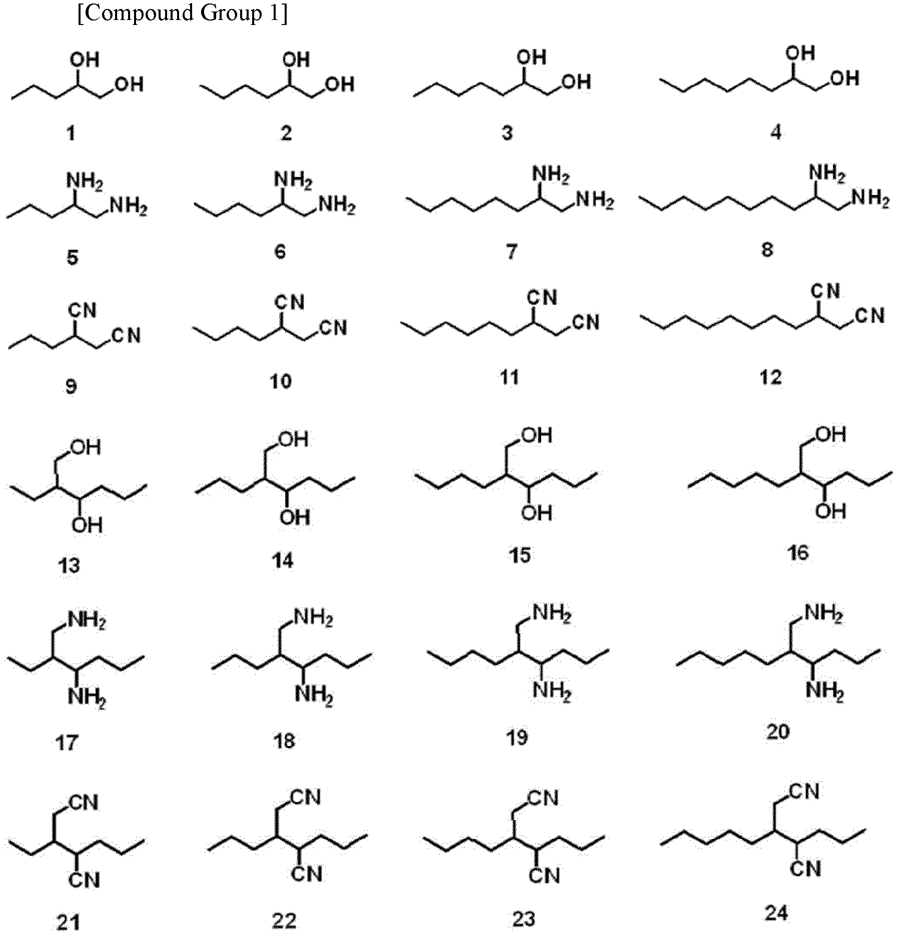

In an embodiment, the metal oxide may include at least one of a first metal oxide represented by Chemical Formula 2 and a second metal oxide represented by Chemical Formula 3.

[Chemical Formula 2] MₐO_{b}

In Chemical Formula 2, M may be Ti, Zr, Sn, W, Ta, Ni, Mo, or Cu; and a and b may each independently be an integer from 1 to 5.

[Chemical Formula 3] Zn_{(1-c)}Q_{c}O

In Chemical Formula 3, Q may include at least one of Mg, Co, Ni, Zr, Mn, Sn, Y, and Al; and c may be equal to or greater than 0 and less than 0.5.

In an embodiment, the metal oxide may include the second metal oxide represented by Chemical Formula 3; and in Chemical Formula 3, Q may be Mg, and c may be 0.12.

According to an embodiment, a light-emitting element includes a first electrode, a first functional layer disposed on the first electrode, a light-emitting layer disposed on the first functional layer, a second functional layer disposed on the light-emitting layer, and a second electrode disposed on the second functional layer, wherein the first and second functional layers each independently include an additive represented by Chemical Formula 1 (For example, one or both of the first and second functional layers includes an additive represented by Chemical Formula 1. For example one of the first and second functional layers includes an additive represented by Chemical Formula 1).

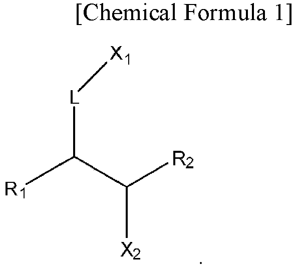

In Chemical Formula 1, X₁ and X₂ are each independently a hydroxy group, a substituted or unsubstituted amine group, or a cyano group; L is a direct linkage or substituted or unsubstituted methylene group; and R₁ and R₂ are each independently a hydrogen atom, or a substituted or unsubstituted alkyl group having 1 to 8 carbon atoms (e.g. 1 to 6 carbon atoms).

In an embodiment, the additive may include at least one compound selected from Compound Group 1, which is explained herein.

In an embodiment, the first functional layer may include a hole transport region; the second functional layer may include an electron transport region; and the electron transport region may include the additive.

In an embodiment, the first functional layer may include an electron transport region; the second functional layer may include a hole transport region; and the electron transport region may include the additive.

In an embodiment, the second functional layer may include an electron transport layer disposed on the light-emitting layer, and an electron injection layer disposed between the electron transport layer and the second electrode; and the electron transport layer may include the additive.

In an embodiment, the light-emitting layer may include quantum dots.

In an embodiment, the quantum dots may each include a core, and a shell surrounding the core.

According to an embodiment, a method for manufacturing a light-emitting element may include: forming a hole transport region on a first electrode; forming a light-emitting layer on the hole transport region; forming an electron transport region on the light-emitting layer; and forming a second electrode on the electron transport region, wherein

the forming of the electron transport region may include forming a preliminary electron transport region by supplying, on the light-emitting layer, an ink composition including a metal oxide and an additive, and supplying heat to the preliminary electron transport region; the ink composition has a viscosity in a range of about 7.5 cP to about 8.0 cP at a temperature of about 25 °C; and the additive is represented by Chemical Formula 1.

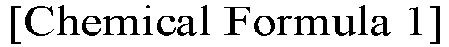

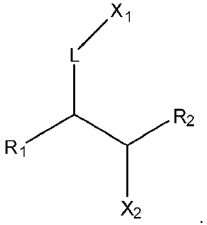

In Chemical Formula 1, X₁ and X₂ are each independently a hydroxy group, a substituted or unsubstituted amine group, or a cyano group; L is a direct linkage or substituted or unsubstituted methylene group; and R₁ and R₂ are each independently a hydrogen atom, or a substituted or unsubstituted alkyl group having 1 to 8 carbon atoms (e.g. 1 to 6 carbon atoms).

In an embodiment, the light-emitting layer may include quantum dots.

In an embodiment, the quantum dots may each include a core and a shell surrounding the core.

At least some of the above and other features of the invention are set out in the claims.

It is to be understood that the embodiments above are described in a generic and explanatory sense only and not for the purposes of limitation, and the disclosure is not limited to the embodiments described above.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will become more apparent by describing in detail embodiments thereof with reference to the accompanying drawings, in which:
FIG. 1 is a schematic perspective view of a display device according to an embodiment;
FIG. 2 is a schematic cross-sectional view of a portion of a display device corresponding to virtual line I-I' in FIG. 1;
FIG. 3 is a schematic plan view of a display device according to an embodiment;
FIGS. 4 and 5 are each a schematic cross-sectional view of a portion of a display device corresponding to virtual line II-II' in FIG. 3;
FIG. 6 is a schematic cross-sectional view of a light-emitting element according to an embodiment;
FIGS. 7 and 8 are each a flowchart illustrating a method for manufacturing a light-emitting element according to an embodiment; and
FIGS. 9 to 16 are each a schematic cross-sectional view illustrating portions of a method for manufacturing a light-emitting element according to an embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and reference characters refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

In the specification, the term "substituted or unsubstituted" may describe a group that is substituted or unsubstituted with one or more substituents selected from the group consisting of a deuterium atom, a halogen atom, a cyano group, a nitro group, an amine group, a silyl group, an oxy group, a thio group, a sulfinyl group, a sulfonyl group, a carbonyl group, a boron group, a phosphine oxide group, a phosphine sulfide group, an alkyl group, an alkoxy group, an alkenyl group, an alkynyl group, a hydrocarbon ring group, an aryl group, and a heterocyclic group. Each of the substituents listed above may itself be substituted or unsubstituted. For example, a biphenyl group may be interpreted as an aryl group, or it may be interpreted as a phenyl group substituted with a phenyl group.

In the specification, examples of the halogen atom may include a fluorine atom, a chlorine atom, a bromine atom, or an iodine atom.

In the specification, an alkyl group may be linear or branched. The number of carbon atoms in an alkyl group may be 1 to 60, 1 to 50, 1 to 30, 1 to 20, 1 to 10, or 1 to 6. Examples of an alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldodecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-icosyl group, a 2-ethylicosyl group, a 2-butylicosyl group, a 2-hexylicosyl group, a 2-octylicosyl group, an n-heneicosyl group, an n-docosyl group, an n-tricosyl group, an n-tetracosyl group, an n-pentacosyl group, an n-hexacosyl group, an n-heptacosyl group, an n-octacosyl group, an n-nonacosyl group , an n-triacontyl group, etc., but embodiments are not limited thereto.

In the specification, an alkoxy group may be an oxygen atom that is bonded to an alkyl group, as defined herein. An alkoxy group may be linear, branched, or cyclic. The number of carbon atoms in an alkoxy group is not particularly limited, and may be 1 to 30, 1 to 20, 1 to 10, or 1 to 5. Examples of an alkoxy group may include a methoxy group, an ethoxy group, an n-propoxy group, an isopropoxy group, a butoxy group, a pentyloxy group, a hexyloxy group, an octyloxy group, a nonyloxy group, a decyloxy group, etc., but embodiments are not limited thereto.

In the specification, the number of carbon atoms in an amine group is not particularly limited, and may be 1 to 30, 1 to 20, or 1 to 10. An amine group may be an alkyl amine group or an aryl amine group. Examples of an amine group may include a methylamine group, a dimethylamine group, a phenylamine group, a diphenylamine group, a naphthylamine group, a 9-methyl-anthracenylamine group, etc., but embodiments are not limited thereto.

In the specification, an alkenyl group refers to a hydrocarbon group including at least one carbon double bond in the middle or terminal of an alkyl group having 2 or more carbon atoms. The alkenyl group may be linear or branched. The number of carbon atoms in the alkenyl group is not specifically limited, but may beis 2 to 30, 2 to 20, or 2 to 10. Examples of the alkenyl group include a vinyl group, a 1-butenyl group, a 1-pentenyl group, a 1,3-butadienyl aryl group, a styrenyl group, a styryl vinyl group, and/or the like, but the embodiment of the present disclosure is not limited thereto.

In the specification, an alkynyl group refers to a hydrocarbon group including at least one carbon triple bond in the middle or terminal of an alkyl group having 2 or more carbon atoms. The alkynyl group may be linear or branched. Although the number of carbon atoms is not specifically limited, it may beis 2 to 30, 2 to 20, or 2 to 10. Specific examples of the alkynyl group may include an ethynyl group, a propynyl group, and/or the like, but are not limited thereto.

In the specification, the hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the specification, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but the embodiment of the present disclosure is not limited thereto.

The heterocyclic group herein refers to any functional group or substituent derived from a ring containing at least one of B, O, N, P, Si, or Se as a heteroatom. The heterocyclic group includes an aliphatic heterocyclic group and an aromatic heterocyclic group. The aromatic heterocyclic group may be a heteroaryl group. The aliphatic heterocycle and the aromatic heterocycle may be monocyclic or polycyclic.

In the specification, the heterocyclic group may contain at least one of B, O, N, P, Si or S as a heteroatom. When the heterocyclic group contains two or more heteroatoms, the two or more heteroatoms may be the same as or different from each other. The heterocyclic group may be a monocyclic heterocyclic group or a polycyclic heterocyclic group, and includes a heteroaryl group. The number of ring-forming carbon atoms in the heterocyclic group may be 2 to 30, 2 to 20, or 2 to 10.

In the specification, the aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but the embodiment of the present disclosure is not limited thereto.

In the specification, the heteroaryl group may contain at least one of B, O, N, P, Si, or S as a heteroatom. When the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, but the embodiment of the present disclosure is not limited thereto.

In the specification, the preceding description of the aryl group may be applied to an arylene group except that the arylene group is a divalent group. The preceding description of the heteroaryl group may be applied to a heteroarylene group except that the heteroarylene group is a divalent group.

In the specification, the silyl group includes an alkylsilyl group and an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but the embodiment of the present disclosure is not limited thereto.

In the specification, the number of carbon atoms in the sulfinyl group and the sulfonyl group is not particularly limited, but may be 1 to 30. The sulfinyl group may include an alkyl sulfinyl group and an aryl sulfinyl group. The sulfonyl group may include an alkyl sulfonyl group and an aryl sulfonyl group.

In the specification, the thio group may include an alkylthio group and an arylthio group. The thio group may refer to that a sulfur atom is bonded to the alkyl group or the aryl group as defined herein. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but the embodiment of the present disclosure is not limited thereto.

In the specification, an oxy group may refer to that an oxygen atom is bonded to the alkyl group or the aryl group as defined herein. The oxy group may include an alkoxy group and an aryl oxy group. The alkoxy group may be a linear chain, a branched chain or a ring chain. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like, but the embodiment of the present disclosure is not limited thereto.

The boron group herein may refer to that a boron atom is bonded to the alkyl group or the aryl group as defined herein. The boron group includes an alkyl boron group and an aryl boron group. Examples of the boron group may include a dimethylboron group, a trimethylboron group, a t-butyldimethylboron group, a diphenylboron group, a phenylboron group, and/or the like, but the embodiment of the present disclosure is not limited thereto.

In the specification, the alkyl group among an alkylthio group, an alkylsulfoxy group, an alkylaryl group, an alkylamino group, an alkyl boron group, an alkyl silyl group, and an alkyl amine group is the same as the examples of the alkyl group described herein.

In the specification, the phosphine oxide group may be substituted with, for example, at least one of the alkyl groups or aryl groups described above.

In the specification, the phosphine sulfide group may be substituted with, for example, at least one of the alkyl groups or aryl groups described above.

In the specification, the number of ring-forming carbon atoms in the carbonyl group is not specifically limited, but may be 1 to 40, 1 to 30, or 1 to 20. For example, the carbonyl group may have the following structures, but the embodiment of the present disclosure is not limited thereto.

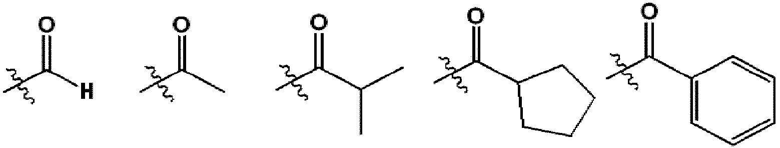

In the specification, a direct linkage may be a single bond.

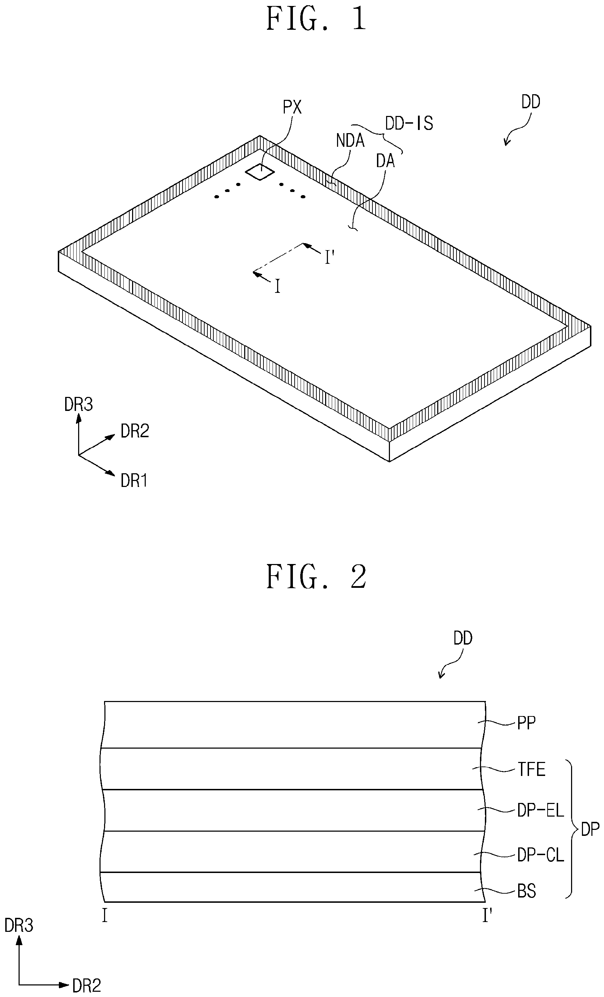

Hereinafter, a light-emitting element according to an embodiment and a display device including the light-emitting element will be described with reference to the drawings. FIG. 1 is a schematic perspective view of a display device according to an embodiment.

Referring to FIG. 1, a display device DD according to an embodiment may be a device that is activated in response to an electrical signal. For example, the display device DD may be a large-sized device such as a television, a monitor, or a billboard. In an embodiment, the display device DD may be a small or medium-sized device such as a personal computer, a notebook computer, a personal digital assistant, a car navigation unit, a game console, a smartphone, a tablet computer, or a camera. However, these are only provided as examples, and the display device DD may be included in other electronic devices.

The display device DD may display an image through a display surface DD-IS. The display surface DD-IS may be parallel to a plane that is defined by a first direction DR1 and a second direction DR2. The display surface DD-IS may include a display region DA and a non-display region NDA.

A pixel PX may be disposed in the display region DA, and the pixel PX may not be disposed in the non-display region NDA. The non-display region NDA may be defined along a border of the display surface DD-IS. The non-display region NDA may surround the display region DA. However, embodiments are not limited thereto, and the non-display region NDA may be omitted, or the non-display region NDA may be disposed only on one side of the display region DA.

FIG. 1 shows the display device DD has a display surface DD-IS that is flat, but embodiments are not limited thereto. For example, in embodiments, the display surface DD-IS of the display device DD may be a curved display surface or a three-dimensional display surface. The three-dimensional display surface may include multiple display regions that are disposed in different directions.

In FIG. 1 and the following drawings, a first directional axis DR1, a second directional axis DR2, and/or a third directional axis DR3 are illustrated. However, the directions indicated by first to third directional axes DR1, DR2, and DR3 described in the specification are relative terms, and may be changed into other directions. The directions indicated by the first to third directional axes DR1, DR2, and DR3 may be respectively described as first to third directions, and may be denoted by the same reference numbers or symbols. In the specification, a first directional axis DR1 and a second directional axis DR2 may be orthogonal to each other, and a third directional axis DR3 may be a normal direction of a plane defined by the first directional axis DR1 and the second directional axis DR2. In the specification, a plan view may refer to a plane defined by the first directional axis DR1 and the second directional axis DR2, and a cross-sectional view may refer to a plane that is orthogonal to the plane defined by the first directional axis DR1 and the second directional axis DR2, and is parallel to the third directional axis DR3. A thickness direction of the display device DD may be a direction that is parallel to the third direction DR3, which is a normal direction of the plane defined by the first direction DR1 and the second direction DR2.

In the specification, the upper surface (or front surface) and the lower surface (or rear surface) of the members that constitute the display device DD may be defined with respect to the third direction DR3. For example, a surface that is relatively adjacent to the display surface DD-IS, among two surfaces that face each other with respect to the third direction DR3, may be defined as the front surface (or upper surface), and a surface that is relatively spaced apart from the display surface DD-IS may be defined as the rear surface (or lower surface). In the specification, the upper portion (upper side) and the lower portion (or lower side) may be defined with respect to the third direction DR3, and the upper portion (or upper side) may be defined as a portion (or side) that is relatively closer to the display surface DD-IS, and the lower portion (lower side) may be defined as a portion (or side) that is relatively farther from the display surface DD-IS.

FIG. 2 is a schematic cross-sectional view of a portion of the display device DD, corresponding to virtual line I-I' in FIG. 1. FIG. 2 may be a schematic cross-sectional view of a display device DD according to an embodiment.

The display device DD may include a display panel DP and an optical layer PP disposed on the display panel DP. The display panel DP may include a base layer BS, a circuit layer DP-CL disposed on the base layer BS, a display element layer DP-EL disposed on the circuit layer DP-CL, and an encapsulation layer TFE disposed on the display element layer DP-EL.

The display panel DP may be a component that generates an image. The display panel DP may be a light-emitting display panel. For example, the display panel DP may be a quantum dot light-emitting display panel that includes a quantum dot light-emitting element.

The base layer BS may provide a base surface on which the circuit layer DP-CL is disposed. The base layer BS may be a rigid substrate, or the base layer BS may be a flexible substrate that is bendable, foldable, or rollable. The base layer BS may be a glass substrate, a metal substrate, a polymer substrate, or the like. However, embodiments are not limited thereto, and the base layer BS may include an inorganic layer, an organic layer, or a composite material layer.

The circuit layer DP-CL may be disposed on the base layer BS. The circuit layer DP-CL may include an insulating layer, a semiconductor pattern, a conductive pattern, a signal line, etc. A semiconductor layer and a conductive layer may each be formed on the base layer BS by being disposed on the insulating layer through a method such as coating and deposition; and the insulating layer, the semiconductor layer, and the conductive layer may be selectively patterned through one or more photolithography processes. The semiconductor pattern, the conductive pattern, and the signal line included in the circuit layer DP-CL may thus be formed.

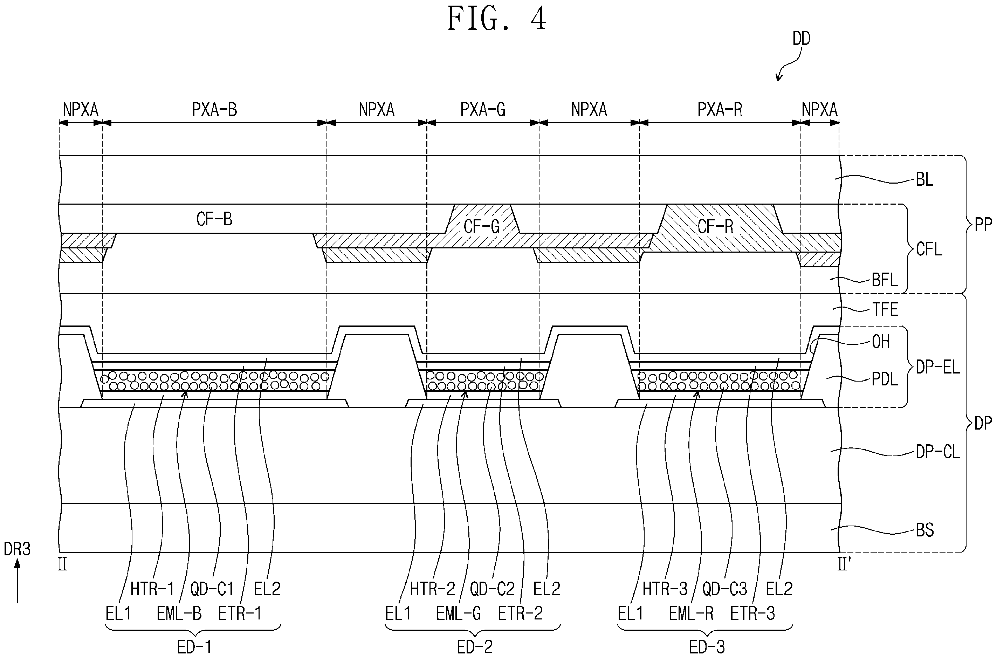

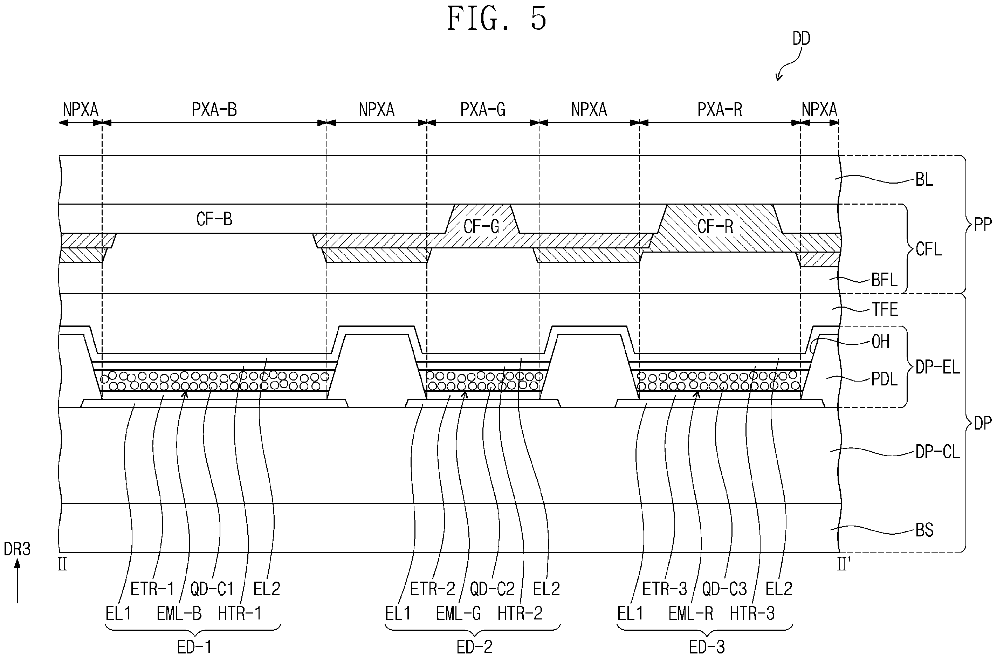

The display element layer DP-EL may be disposed on the circuit layer DP-CL. The display element layer DP-EL may include a pixel-defining film PDL (see FIGS. 4 and 5) and first to third light-emitting elements ED-1, ED-2, and ED-3 (see FIGS. 4 and 5), which will be described later. For example, the display element layer DP-EL may include an organic light-emitting material, an inorganic light-emitting material, an organic-inorganic light-emitting material, a quantum dot, a quantum rod, a micro-LED, or a nano-LED. For example, the display element layer DP-EL may include quantum dots.

The encapsulation layer TFE may protect the display element layer DP-EL from moisture, oxygen, and foreign matter such as dust particles. The encapsulation layer TFE may include at least one inorganic layer. The encapsulation layer TFE may have a structure in which an inorganic layer, an organic layer, and an inorganic layer are sequentially stacked.

The optical layer PP may be disposed on the display panel DP to control light that is reflected at the display panel DP from an external light. For example, the optical layer PP may include a polarizing layer (not shown) or a color filter layer CFL (see FIGS. 4 and 5). Although not shown in the drawings, in an embodiment, the optical layer PP may be omitted.

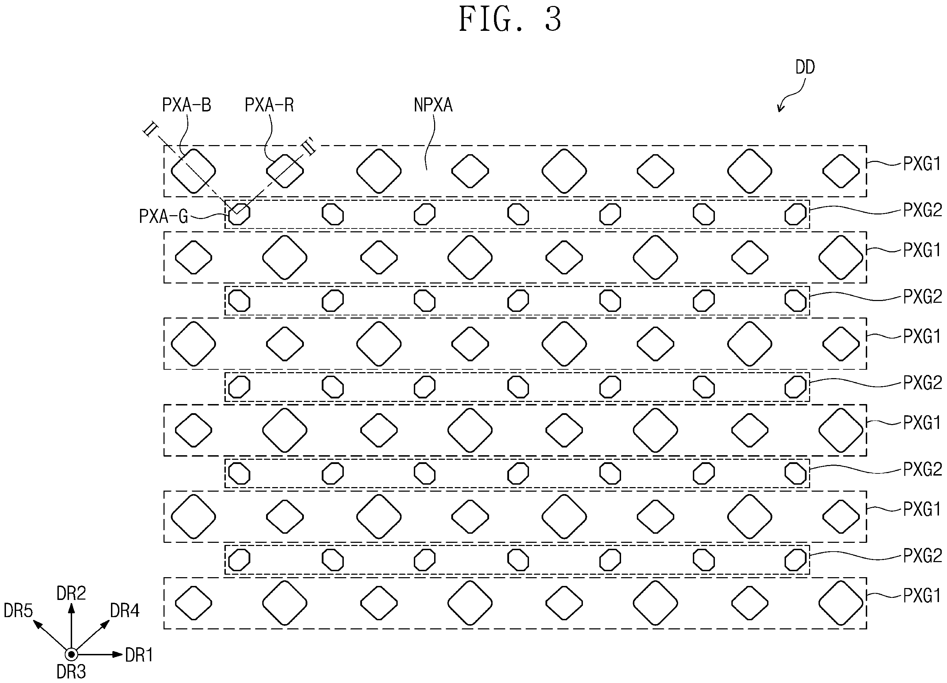

FIG. 3 is a schematic plan view of a display device DD according to an embodiment. FIGS. 4 and 5 are each a schematic cross-sectional view of a portion of a display device DD corresponding to virtual line II-II' in FIG. 3. FIGS. 4 and 5 may each be a schematic cross-sectional view of a display device according to an embodiment.

Referring to FIGS. 3 to 5, a display device DD may include a peripheral region NPXA and light-emitting regions PXA-B, PXA-G, and PXA-R. The light-emitting regions PXA-B, PXA-G, and PXA-R may be regions that emit light respectively generated by light-emitting elements ED-1, ED-2, and ED-3. The light-emitting regions PXA-B, PXA-G, and PXA-R may each have a different area, in which the areas may be areas in a plan view.

The light-emitting regions PXA-B, PXA-G, and PXA-R may be arranged into groups according to the colors of light generated by the light-emitting elements ED-1, ED-2, and ED-3. FIGS. 3 to 5 illustrate three light-emitting regions PXA-B, PXA-G, and PXA-R that respectively emit red light, green light, and blue light. For example, the display device DD may include a blue light-emitting region PXA-B, a green light-emitting region PXA-G, and a red light-emitting region PXA-R that are distinct from each other.

A display panel DP may include multiples of each of the light-emitting elements ED-1, ED-2, and ED-3 that respectively emit light having different wavelength regions. The light-emitting elements ED-1, ED-2, and ED-3 may emit light having different colors from each other. For example, the display panel DP may include a first light-emitting element ED-1 that emits red light, a second light-emitting element ED-2 that emits green light, and a third light-emitting element ED-3 that emits blue light. However, embodiments are not limited thereto, and the first to third light-emitting elements ED-1, ED-2, and ED-3 may emit light having a same wavelength region, or at least one of the light-emitting elements may emit light in a wavelength region that is different from the remainder.

In the display device DD according to an embodiment as illustrated in FIGS. 3 to 5, the light-emitting regions PXA-B, PXA-G, and PXA-R may have areas that are different in size or shape from each other, according to the colors of light that are emitted by light-emitting layers EML-B, EML-G, and EML-R of the light-emitting elements ED-1, ED-2, and ED-3. The blue light-emitting region PXA-B of the first light-emitting element ED-1 that emits blue light may have the largest area, and the green light-emitting region PXA-G of the second light-emitting element ED-2 that emits green light may have the smallest area. However, embodiments are not limited thereto, and the light-emitting regions PXA-B, PXA-G, and PXA-R may emit light having colors other than red light, green light, or blue light. In an embodiment, the light-emitting regions PXA-B, PXA-G, and PXA-R may have a same area, or they may have areas that are provided in proportions that are different from what is illustrated in FIG. 3.

The light-emitting regions PXA-B, PXA-G, and PXA-R may be separated from each other by a pixel-defining film PDL. The peripheral regions NPXA may be regions between adjacent light-emitting regions PXA-B, PXA-G, and PXA-R, and which may correspond to the pixel-defining film PDL. In an embodiment, the light-emitting regions PXA-B, PXA-G, and PXA-R may each correspond to a pixel.

The pixel-defining film PDL may define the light-emitting regions PXA-B, PXA-G, and PXA-R. The light-emitting regions PXA-B, PXA-G, and PXA-R may be separated from the peripheral region NPXA by the pixel-defining film PDL.

The blue light-emitting region PXA-B and the red light-emitting region PXA-R may be alternately arranged along the first directional axis DR1 to constitute a first group PXG1. The green light-emitting regions PXA-G may be arranged along the first directional axis DR1 to constitute a second group PXG2. The first group PXG1 may be disposed so that it is spaced apart from the second group PXG2 along the second directional axis DR2. The first group PXG1 and the second group PXG2 may be provided in a repeating pattern. The first group PXG1 and the second group PXG2 may be alternately arranged along the second directional axis DR2.

A red light-emitting region PXA-R may be disposed so that it is spaced apart from a green light-emitting region PXA-G along a fourth directional axis DR4. A blue light-emitting region PXA-B may be disposed so that it is spaced apart from a green light-emitting region PXA-G along a fifth directional axis DR5. The fourth directional axis DR4 may be a direction between the first directional axis DR1 and the second directional axis DR2. The fifth directional axis DR5 may be a direction that crosses the fourth directional axis DR4, and may be a direction that is inclined toward the second directional axis DR2.

In an embodiment, an arrangement of the light-emitting regions PXA-B, PXA-G, and PXA-R is not limited to the arrangement that is shown in FIG. 3. For example, in an embodiment, the red light-emitting region PXA-R, the green light-emitting region PXA-G, and the blue light-emitting region PXA-B may be arranged in this order as a repeating sequence along the first directional axis DR1. In an embodiment, the shapes of each of the light-emitting regions PXA-B, PXA-G, and PXA-R are not limited to what is shown in FIG. 3, and may each be defined as a shape that is different from what is illustrated.

In the display device DD (for example, as shown in FIG. 4), the base layer BS may have a single-layered structure or a multi-layered structure. In an embodiment, the base layer BS may include a first synthetic resin layer, an intermediate layer having a single-layered structure or a multi-layered structure, and a second synthetic resin layer, which may be stacked in that order. The intermediate layer may be referred to as a base barrier layer. The intermediate layer may include a silicon oxide (SiOₓ) layer and an amorphous silicon (a-Si) layer disposed on the silicon oxide layer, but embodiments are not limited thereto. For example, the intermediate layer may include at least one of a silicon oxide layer, a silicon nitride layer, a silicon oxynitride layer, and an amorphous silicon layer.

The first and second synthetic resin layers may each include a polyimide-based resin. In an embodiment, the first and second synthetic resin layers may each independently include at least one of an acrylic resin, a methacrylate-based resin, a polyisoprene-based resin, a vinyl-based resin, an epoxy-based resin, a urethane-based resin, a cellulose-based resin, a siloxane-based resin, a polyamide-based resin, and a perylene-based resin. In the specification, the term "X-based resin" refers to a resin that includes an "X" functional group.

The circuit layer DP-CL may be disposed on the base layer BS, and the circuit layer DP-CL may include transistors (not shown). The transistors (not shown) may each include a control electrode, an input electrode, and an output electrode. For example, the circuit layer DP-CL may include a switching transistor and a driving transistor for driving the light-emitting elements ED-1, ED-2, and ED-3 of a display element layer DP-EL.

The display element layer DP-EL may include the pixel-defining film PDL and the first to third light-emitting elements ED-1, ED-2, and ED-3. Openings OH may be defined in the pixel-defining film PDL. The pixel-defining film PDL may separate the first to third light-emitting elements ED-1, ED-2, and ED-3. The light-emitting layers EML-B, EML-G, and EMI,-R of the first to third light-emitting elements ED-1, ED-2, and ED-3 may each be disposed in the openings OH defined in the pixel-defining film PDL, so that they are separated from each other.

The pixel-defining film PDL may be formed of a polymer resin. For example, the pixel-defining film PDL may include a polyacrylate-based resin or a polyimide-based resin. In an embodiment, the pixel-defining film PDL may further include an inorganic material, in addition to the polymer resin. The pixel-defining film PDL may include a light-absorbing material, or may include a black pigment or a black dye. The pixel-defining film PDL that includes a black pigment or a black dye may be implemented as a black pixel-defining film. When the pixel-defining film PDL is formed, carbon black or the like may be used as the black pigment or black dye, but embodiments are not limited thereto.

In an embodiment, the pixel-defining film PDL may be formed of an inorganic material. For example, the pixel-defining film PDL may include an inorganic material such as silicon nitride (SiNₓ), silicon oxide (SiOₓ), silicon oxynitride (SiOₓN_{y}), or the like.

The light-emitting elements ED-1, ED-2, and ED-3 may each include a first electrode EL1, a first functional layer, a light-emitting layer EML, a second functional layer, and a second electrode EL2. The first functional layer may be disposed between the first electrode EL1 and the light-emitting layer EML, and the second functional layer may be disposed between the light-emitting layer EML and the second electrode EL2.

In FIG. 4, the light-emitting elements ED-1, ED-2, and ED-3 may each include the first electrode EL1, a hole transport region HTR-1, HTR-2, or HTR-3 disposed on the first electrode EL1, a light-emitting layer EML-B, EML-G, or EML-R disposed on the hole transport region HTR-1, HTR-2, or HTR-3, an electron transport region ETR-1, ETR-2, or ETR-3 disposed on the light-emitting layer EML-B, EML-G, or EMI,-R and the second electrode EL2 disposed on the electron transport region ETR-1, ETR-2, or ETR-3. The first functional layer may include a hole transport region HTR. For example, the first functional layer may be the hole transport region HTR. The second functional layer may include an electron transport region ETR. For example, the second functional layer may be the electron transport region ETR.

In FIG. 5, the light-emitting elements ED-1, ED-2, and ED-3 may each include the first electrode EL1, the electron transport region ETR-1, ETR-2, or ETR-3 disposed on the first electrode EL1, the light-emitting layer EML-B, EML-G, or EML-R disposed on the electron transport region ETR-1, ETR-2, or ETR-3, the hole transport region HTR-1, HTR-2, or HTR-3 disposed on the light-emitting layer EML-B, EML-G, or EMI,-R, and the second electrode EL2 disposed on the hole transport region HTR-1, HTR-2, or HTR-3. The first functional layer may include the electron transport region ETR. For example, the first functional layer may be the electron transport region ETR. The second functional layer may include the hole transport region HTR. For example, the second functional layer may be the hole transport region HTR.

Referring to FIGS. 4 and 5, at least a portion of the first electrode EL1 may be exposed in the openings OH defined in the pixel-defining film PDL. The first electrode EL1 has a conductive property. The first electrode EL1 may be formed of a metal material, a metal alloy, or a conductive compound. The first electrode EL1 may be a cathode or an anode. However, embodiments are not limited thereto. In an embodiment, the first electrode EL1 may be a pixel electrode. The first electrode EL1 may be a transmissive electrode, a semi-transmissive electrode, or a reflective electrode. The first electrode EL1 may include at least one of Ag, Mg, Cu, Al, Pt, Pd, Au, Ni, Nd, Ir, Cr, Li, Ca, LiF, Mo, Ti, W, In, Sn, Zn, an oxide thereof, a compound thereof, and a mixture thereof.

When the first electrode EL1 is a transmissive electrode, the first electrode EL1 may include a transparent metal oxide, for example, indium-tin oxide (ITO), indium-zinc oxide (IZO), zinc oxide (ZnO), indium-tin-zinc oxide (ITZO), or the like. When the first electrode EL1 is a semi-transmissive electrode or a reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (for example, a mixture of Ag and Mg). In an embodiment, the first electrode EL1 may have a structure that includes a reflective film or a semi-transmissive film formed of the materials described above, and a transparent conductive film formed of indium-tin oxide (ITO), indium-zinc oxide (IZO), zinc oxide (ZnO), indium-tin-zinc oxide (ITZO), or the like. For example, the first electrode EL1 may have a three-layered structure of ITO/Ag/ITO, but embodiments are not limited thereto. In embodiments, the first electrode EL1 may include a metal material as described above, a combination of at least two metal materials as described above, or an oxide of a metal material as described above. The first electrode EL1 may have a thickness in a range of about 700 Å to about 10,000 Å. For example, the first electrode EL1 may have a thickness in a range of about 1,000 Å to about 3,000 Å.

The second electrode EL2 may be a common electrode. The second electrode EL2 may be a cathode or an anode, but embodiments are not limited thereto. For example, when the first electrode EL1 is an anode, the second electrode EL2 may be a cathode, and when the first electrode EL1 is a cathode, the second electrode EL2 may be an anode. The second electrode EL2 may include at least one of Ag, Mg, Cu, Al, Pt, Pd, Au, Ni, Nd, Ir, Cr, Li, Ca, LiF, Mo, Ti, W, In, Sn, Zn, an oxide thereof, a compound thereof, and a mixture thereof.

The second electrode EL2 may be a transmissive electrode, a semi-transmissive electrode, or a reflective electrode. When the second electrode EL2 is a transmissive electrode, the second electrode EL2 may be composed of a transparent metal oxide, for example, indium-tin oxide (ITO), indium-zinc oxide (IZO), zinc oxide (ZnO), indium-tin-zinc oxide (ITZO), or the like.

When the second electrode EL2 is a semi-transmissive electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (for example, AgMg, AgYb, or MgYb). In an embodiment, the second electrode EL2 may have a structure that includes a reflective film or semi-transmissive film formed of the materials described above, and a transparent conductive film formed of indium-tin oxide (ITO), indium-zinc oxide (IZO), zinc oxide (ZnO), indium-tin-zinc oxide (ITZO), or the like. In embodiments, the second electrode EL2 may include a metal material as described above, a combination of at least two of the metal materials as described above, an oxide of a metal material as described above, or the like.

Although not shown in the drawings, the second electrode EL2 may be electrically connected to an auxiliary electrode. When the second electrode EL2 is electrically connected to the auxiliary electrode, resistance of the second electrode EL2 may be reduced.

The light-emitting layers EMI,-B, EML-G, and EML-R may each be disposed between the first electrode EL1 and the second electrode EL2. The first light-emitting element ED-1 may include a first light-emitting layer EML-B, the second light-emitting element ED-2 may include a second light-emitting layer EML-G, and the third light-emitting element ED-3 may include a third light-emitting layer EML-R. The first light-emitting layer EML-B may include first quantum dots QD-C1. The second light-emitting layer EMI,-G may include second quantum dots QD-C2. The third light-emitting layer EMI,-R may include third quantum dots QD-C3.

The quantum dots QD-C1, QD-C2, and QD-C3 respectively included in the light-emitting layers EMI,-B, EML-G, and EMI,-R may be each stacked to form at least one layer. FIGS. 4 and 5 illustrate that the quantum dots QD-C1, QD-C2, or QD-C3, which each have circular cross-sections, are arranged to form approximately two layers, but embodiments are not limited thereto. For example, an arrangement of the quantum dots QD-C1, QD-C2, and QD-C3 may be changed according to parameters such as a thickness of the light-emitting layers EML-B, EML-G, and EML-R, a shape of the quantum dots QD-C1, QD-C2, and QD-C3 included in the light-emitting layers EML-B, EMI,-G, and EML-R, and an average diameter of the quantum dots QD-C1, QD-C2, and QD-C3. In an embodiment, in the light-emitting layers EML-B, EML-G, and EML-R, the quantum dots QD-C1, QD-C2, and QD-C3 may be aligned adjacent to each other to form one layer, or may be aligned to form multiple layers such as two layers or three layers.

The first quantum dots QD-C1 of the first light-emitting element ED-1 may emit blue light. The second quantum dots QD-C2 of the second light-emitting element ED-2 may emit green light. The third quantum dots QD-C3 of the third light-emitting element ED-3 may emit blue light.

FIG. 4 illustrates that the first to third quantum dots QD-C1, QD-C2, and QD-C3 have a similar diameter to each other, but embodiments are not limited thereto. In embodiments, the diameters of the first to third quantum dots QD-C1, QD-C2, and QD-C3 may be different from each other. For example, the first quantum dots QD-C1 of the first light-emitting element ED-1, which emit light in a relatively shorter wavelength region may have a smaller average diameter as compared to an average diameter of the second quantum dots QD-C2 of the second light-emitting element ED-2 and an average diameter of the third quantum dots QD-C3 of the third light-emitting element ED-3, which may each emit light in relatively longer wavelength regions. In the specification, an average diameter may be an arithmetic mean of the particle diameters of the quantum dots. In the specification, a particle diameter of a quantum dot may be an average value of the widths of the quantum dot particles as measured on cross-sections thereof.

The hole transport regions HTR-1, HTR-2, and HTR-3 of the first to third light-emitting elements ED-1, ED-2, and ED-3 may each be disposed in the openings OH so that they are separated from each other. The first light-emitting element ED-1 may include a first hole transport region HTR-1, the second light-emitting element ED-2 may include a second hole transport region HTR-2, and the third light-emitting element ED-3 may include a third hole transport region HTR-3.

The first to third hole transport regions HTR-1, HTR-2, and HTR-3 may each independently have a structure consisting of a layer consisting of a single material, a structure consisting of a layer including different materials, or a structure including multiple layers including different materials. In embodiments, the first to third hole transport regions HTR-1, HTR-2, and HTR-3 may each independently have a thickness in a range of about 50 Å to about 15,000 Å. For example, the first to third hole transport regions HTR-1, HTR-2, and HTR-3 may each independently have a thickness in a range of about 100 Å to about 10,000 Å. For example, the first to third hole transport regions HTR-1, HTR-2, and HTR-3 may each independently have a thickness in a range of about 100 Å to about 5,000 Å.

The first to third hole transport regions HTR-1, HTR-2, and HTR-3 may each independently further include a hole injection material of the related art and/or a hole transport material of the related art. For example, the first to third hole transport regions HTR-1, HTR-2, and HTR-3 may each independently include a phthalocyanine compound such as copper phthalocyanine, DNTPD (N1,N1'-([1,1'-biphenyl]-4,4'-diyl)bis(N1-phenyl-N4,N4-di-m-tolylbenzene-1,4-diamine)), m-MTDATA (4,4',4"-[tris(3-methylphenyl)phenylamino] triphenylamine), TDATA (4,4',4"-tris(N,N-diphenylamino)triphenylamine), 2-TNATA (4,4',4"-tris[N(2-naphthyl)-N-phenylamino]-triphenylamine), PEDOT/PSS (poly(3,4-ethylenedioxythiophene)/poly(4-styrenesulfonate)), PANI/DBSA (polyaniline/dodecylbenzenesulfonicacid), PANI/CSA (polyaniline/camphorsulfonicacid), PANI/PSS (polyaniline/poly(4-styrenesulfonate)), NPB (N,N'-di(naphthalene-1-yl)-N,N'-diphenyl-benzidine), polyetherketone containing triphenylamine (TPAPEK), 4-isopropyl-4'-methyldiphenyliodonium[tetrakis(pentafluorophenyl)borate], HATCN (dipyrazino[ 2,3-f: 2',3'-h]quinoxaline-2,3,6,7,10,11-hexacarbonitrile), or the like.

In embodiments, the first to third hole transport regions HTR-1, HTR-2, and HTR-3 may each independently include a carbazole-based derivative such as N-phenylcarbazole or polyvinylcarbazole, a fluorene-based derivative, TPD (N,N'-bis(3-methylphenyl)-N,N'-diphenyl-[1,1'-biphenyl]-4,4'-diamine), a triphenylamine derivative such as TCTA (4,4',4"-tris(N-carbazolyl)triphenylamine), NPB (N,N'-di(naphthalene-1-yl)-N,N'-diphenyl-benzidine), TAPC (4,4'-cyclohexylidenebis[N,N-bis(4-methylphenyl)benzenamine]), HMTPD (4,4'-bis[N,N'-(3-tolyl)amino]-3,3'-dimethylbiphenyl), CzSi (9-(4-tert-butylphenyl)-3,6-bis(triphenylsilyl)-9H-carbazole), CCP (9-phenyl-9H-3,9'-bicarbazole), mCP (1,3-bis(N-carbazolyl)benzene), mDCP (1,3-bis(1,8-dimethyl-9H-carbazol-9-yl)benzene), or the like.

The electron transport regions ETR-1, ETR-2, and ETR-3 of the first to third light-emitting elements ED-1, ED-2, and ED-3 may each be disposed in the openings OH so that they are separated from each other. The first light-emitting element ED-1 may include a first electron transport region ETR-1, the second light-emitting element ED-2 may include a second electron transport region ETR-2, and the third light-emitting element ED-3 may include a third electron transport region ETR-3.

The first to third electron transport regions ETR-1, ETR-2, and ETR-3 may each independently have a structure consisting of a layer consisting of a single material, a structure consisting of a layer including different materials, or a structure including multiple layers including different materials. In embodiments, the first to third electron transport regions ETR-1, ETR-2, and ETR-3 may each independently have a thickness in a range of about 1,000 Å to about 1,500 Å.

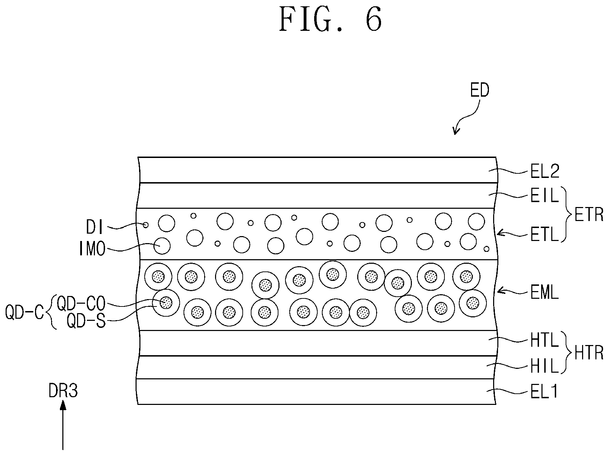

The first functional layer or the second functional layer may include an additive DI (see FIG. 6). For example, as shown in FIG. 4, the first functional layer may include the first to third hole transport regions HTR-1, HTR-2, and HTR-3, the second functional layer may include the first to third electron transport regions ETR-1, ETR-2, and ETR-3, and the first to third hole transport regions HTR-1, HTR-2, and HTR-3 may include the additive DI. In an embodiment as shown in FIG. 4, the first functional layer may include the first to third hole transport regions HTR-1, HTR-2, and HTR-3, the second functional layer may include the first to third electron transport regions ETR-1, ETR-2, and ETR-3, and the first to third electron transport regions ETR-1, ETR-2, and ETR-3 may include the additive DI (see FIG. 6). In an embodiment as shown in FIG. 5, the first functional layer may include the first to third electron transport regions ETR-1, ETR-2, and ETR-3, the second functional layer may include the first to third hole transport regions HTR-1, HTR-2, and HTR-3, and the first to third hole transport regions HTR-1, HTR-2, and HTR-3 may include the additive DI. In an embodiment as shown in FIG. 5, the first functional layer may include the first to third electron transport regions ETR-1, ETR-2, and ETR-3, the second functional layer may include the first to third first to third hole transport regions HTR-1, HTR-2, and HTR-3, and the first to third electron transport regions ETR-1, ETR-2, and ETR-3 may include the additive DI. Descriptions with respect to FIG. 6 are based on an embodiment in which the additive DI (see FIG. 6) is included in the electron transport region ETR (see FIG. 6).

The first to third electron transport regions ETR-1, ETR-2, and ETR-3 may each independently further include an electron injection material of the related art and/or an electron transport material of the related art. For example, the first to third electron transport regions ETR-1, ETR-2, and ETR-3 may each include an anthracene-based compound. In embodiments, the first to third electron transport regions ETR-1, ETR-2, and ETR-3 may each independently include, for example, Alq3 (tris(8-hydroxyquinolinato)aluminium), 1,3,5-tri[(3-pyridyl)-phen-3-yl]benzene, 2,4,6-tris(3'-(pyridin-3-yl))biphenyl-3-yl)-1,3,5-triazine, 2-(4-(N-phenylbenzoimidazol-1-yl)phenyl)-9,10-dinaphthylanthracene, TPBi (1,3,5-tri(1-phenyl-1H-benzo[d]imidazol-2-yl)benzene), BCP (2,9-dimethyl-4,7-diphenyl-1,10-phenanthroline), Bphen (4,7-diphenyl-1,10-phenanthroline), TAZ (3-(4-biphenylyl)-4-phenyl-5-tert-butylphenyl-1,2,4-triazole), NTAZ (4-(naphthalen-1-yl)-3,5-diphenyl)-4H-1,2,4-triazole), tBu-PBD (2-(4-biphenylyl)-5-(4-tert-butylphenyl)-1,3,4-oxadiazole), BAlq (bis(2-methyl-8-quinolinolato-N1,O8)-(1,1'-biphenyl-4-olato)aluminium), Bebq2 (beryllium bis(benzoquinolin-10-olate)), ADN (9,10-di(naphthalene-2-yl))anthracene), BmPyPhB (1,3-bis[3,5-di(pyridin-3-yl)phenyl]benzene), or a mixture thereof. In embodiments, the first to third electron transport regions ETR-1, ETR-2, and ETR-3 may each independently include BCP (2,9-dimethyl-4,7-diphenyl-1,10-phenanthroline), TSPO1 (diphenyl(4-(triphenylsilyl)phenyl)phosphine oxide), Bphen (4,7-diphenyl-1,10-phenanthroline), or the like.

The encapsulation layer TFE may include at least one inorganic film (hereinafter, an encapsulation inorganic film). In an embodiment, the encapsulation layer TFE may include at least one organic film (hereinafter, an encapsulation organic film) and at least one encapsulation inorganic film.

The encapsulation inorganic film may protect the display element layer DP-EL from moisture and/or oxygen, and the encapsulation organic film may protect the display element layer DP-EL from foreign matter such as dust particles. The encapsulation inorganic film may include silicon nitride, silicon oxynitride, silicon oxide, titanium oxide, aluminium oxide, or the like, but embodiments are not limited thereto. The encapsulation organic film may include an acrylic compound, an epoxy-based compound, or the like. The encapsulation organic film may include a photopolymerizable organic material, but embodiments are not limited thereto.

An optical layer PP may include a base substrate BL and a color filter layer CFL. The base substrate BL may provide a base surface on which the color filter layer CFL is disposed. The base substrate BL may be a glass substrate, a metal substrate, a plastic substrate, or the like. However, embodiments are not limited thereto, and the base substrate BL may include an inorganic layer, an organic layer, or a composite material layer.

The color filter layer CFL may include first to third filters CF-B, CF-G, and CF-R. The first to third filters CF-B, CF-G, and CF-R may be disposed to respectively correspond to the first to third light-emitting elements ED-1, ED-2, and ED-3. For example, a first filter CF-B may be a blue filter, a second filter CF-G may be a green filter, and a third filter CF-R may be a red filter. The first to third filters CF-B, CF-G, and CF-R may be disposed so that they respectively correspond to the first to third light-emitting regions PXA-B, PXA-G, and PXA-R.

Each of the first to third filters CF-B, CF-G, and CF-R may each include a polymeric photosensitive resin, and a pigment or a dye. The first filter CF-B may include a blue pigment or a blue dye, the second filter CF-G may include a green pigment or a green dye, and the third filter CF-R may include a red pigment or a red dye. However, embodiments are not limited thereto, and the first filter CF-B may not include a pigment or a dye. The first filter CF-B may include a polymeric photosensitive resin, and may not include a pigment or a dye. The first filter CF-B may be transparent. The first filter CF-B may be formed of a transparent photosensitive resin.

The color filter layer CFL may further include a buffer layer BFL. For example, the buffer layer BFL may serve as a protective layer that protects the first to third filters CF-B, CF-G, and CF-R. The buffer layer BFL may be an inorganic material layer that includes at least one of silicon nitride, silicon oxynitride, and silicon oxide. The buffer layer BFL may be formed of a single layer or of multiple layers.

In an embodiment, the second filter CF-G and the third filter CF-R may each be a yellow filter. The second filter CF-G and the third color filter CF-R may not be provided as separate filter and may be provided as a unitary filter.

Although not shown in the drawings, the color filter layer CFL may further include a light-blocking portion (not shown). The light-blocking portion (not shown) may be a black matrix. The light-blocking portion (not shown) may include an organic light-blocking material or an inorganic light-blocking material, each including a black pigment or a black dye. The light-blocking portion (not shown) may prevent light leakage and may separate boundaries between adjacent filters CF-B, CF-G, and CF-R.

FIG. 6 is a schematic cross-sectional view of a light-emitting element ED according to an embodiment. FIG. 6 may be a schematic cross-sectional view illustrating a portion of the light-emitting element ED (for example, ED-1, ED-2, or ED-3) according to an embodiment illustrated in FIG. 4.

Referring to FIG. 6, the light-emitting element ED may include a first electrode EL1, a hole transport region HTR, a light-emitting layer EML, an electron transport region ETR, and a second electrode EL2, which are stacked in that order. The hole transport region HTR may include a hole injection layer HIL and a hole transport layer HTL. The hole injection layer HIL may be disposed on the first electrode EL1, and the hole transport layer HTL may be disposed on the hole injection layer HIL. The electron transport region ETR may include an electron transport layer ETL and an electron injection layer EIL. The electron injection layer EIL may be disposed on the electron transport layer ETL, and the second electrode EL2 may be disposed on the electron injection layer EIL. Although not shown in FIG. 6, in another embodiment, the light-emitting element ED may include the first electrode EL1, the electron transport region ETR, the light-emitting layer EML, the hole transport region HTR, and the second electrode EL2, stacked in that order. For example, the electron injection layer EIL may be disposed on the first electrode EL1. For example, the electron transport layer ETL may be disposed on the electron injection layer EIL. For example, the hole injection layer HIL may be disposed on the hole transport layer HTL. For example, the second electrode EL2 may be disposed on the hole injection layer HIL.

As shown in FIG. 6, the quantum dots QD-C may each include a core QD-CO, and a shell QD-S surrounding the core. Accordingly, the quantum dots QD-C may each have a core-shell structure. In an embodiment, the cores QD-CO of the quantum dots QD-C may each include materials that are different from each other. In another embodiment, the cores QD-CO of the quantum dots QD-C may each include a same material. In yet another embodiment, two cores QD-CO selected from the cores QD-CO of the quantum dots QD-C may each include a same material, and the remainder of the cores QD-CO may each include different materials from each other.

In the specification, the quantum dot QD-C may be a crystal of a semiconductor compound. The quantum dot QD-C may emit light having various wavelengths according to a size of the crystal. In an embodiment, the quantum dot QD-C may have a diameter in a range of about 1 nm to about 10 nm.

The quantum dot QD-C may be synthesized by a wet chemical process, a metal organic chemical vapor deposition process, a molecular beam epitaxy process, or any process similar thereto. The wet chemical process is a method in which an organic solvent and a precursor material are mixed together to grow quantum dot particle crystals. When the crystals grow, the organic solvent may further serve as a dispersant that is coordinated on the surface of the quantum dot crystals, and may control growth of the crystals. Accordingly, the wet chemical process may be more readily performed than a vapor deposition process such as a metal organic chemical vapor deposition (MOCVD) process or a molecular beam epitaxy (MBE) process, and may control growth of quantum dot particle crystals through a low-cost process.

The quantum dot QD-C may include a Group II-VI semiconductor compound, a Group I-II-VI semiconductor compound, a Group II-IV-VI semiconductor compound, a Group I-II-IV-VI semiconductor compound, a Group III-V semiconductor compound, a Group III-VI semiconductor compound, a Group I-III-VI semiconductor compound, a Group IV-VI semiconductor compound, a Group II-IV-V semiconductor compound, a Group IV element or compound, or any combination thereof. In the specification, the term "Group" refers to a group in the IUPAC periodic table.

Examples of a Group II-VI semiconductor compound may include: a binary compound such as CdS, CdSe, CdTe, ZnS, ZnSe, ZnTe, ZnO, HgS, HgSe, HgTe, MgSe, or MgS; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound such as CdZnSeS, CdZnSeTe, CdZnSTe, CdHgSeS, CdHgSeTe, CdHgSTe, HgZnSeS, HgZnSeTe, or HgZnSTe; and any combination thereof. In an embodiment, a Group II-VI semiconductor compound may further include a Group I metal and/or a Group IV element. Examples of a Group I-II-VI compound may include CuSnS and CuZnS, and examples of a Group II-IV-VI compound may include ZnSnS, and the like. Examples of a Group I-II-IV-VI compound may include a quaternary compound such as Cu₂ZnSnS₂, Cu₂ZnSnS₄, Cu₂ZnSnSe₄, Ag₂ZnSnS₂, and any combination thereof.

Examples of a Group III-V semiconductor compound may include: a binary compound such as GaN, GaP, GaAs, GaSb, AlN, AlP, AlAs, AlSb, InN, InP, InAs, or InSb; a ternary compound such as GaNP, GaNAs, GaNSb, GaPAs, GaPSb, AlNP, AlNAs, AlNSb, AlPAs, AlPSb, InGaP, InNP, InAlP, InNAs, InNSb, InPAs, or InPSb; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb; and any combination thereof. In an embodiment, a Group III-V semiconductor compound may further include a Group II element. Examples of a Group III-V semiconductor compound further including a Group II element may include InZnP, InGaZnP, InAlZnP, or the like.

Examples of a Group III-VI semiconductor compound may include: a binary compound such as GaS, Ga₂S₃, GaSe, Ga₂Se₃, GaTe, InS, InSe, In₂Se₃, or InTe; a ternary compound such as InGaS₃, or InGaSe₃; and any combination thereof.

Examples of a Group I-III-VI semiconductor compound may include: a ternary compound such as AgInS, AgInS₂, AgInSe₂, AgGaS, AgGaS₂, AgGaSe₂, CuInS, CuInS₂, CuInSe₂, CuGaS₂, CuGaSe₂, CuGaO₂, AgGaO₂, or AgAlO₂; a quaternary compound such as AgInGaS₂, or AgInGaSe₂; and any combination thereof.

Examples of a Group IV-VI semiconductor compound may include: a binary compound such as SnS, SnSe, SnTe, PbS, PbSe, or PbTe; a ternary compound such as SnSeS, SnSeTe, SnSTe, PbSeS, PbSeTe, PbSTe, SnPbS, SnPbSe, or SnPbTe; a quaternary compound such as SnPbSSe, SnPbSeTe, or SnPbSTe; and any combination thereof.

Examples of a Group II-IV-V semiconductor compound may include: a ternary compound such as ZnSnP, ZnSnP₂, ZnSnAs₂, ZnGeP₂, ZnGeAs₂, CdSnP₂, CdGeP₂; and any combination thereof.

Examples of a Group IV element or compound may include: a single element such as Si, or Ge; a binary compound such as SiC or SiGe; and any combination thereof.

Each element included in a compound, such as a binary compound, a ternary compound, or a quaternary compound, may be present in a particle at a uniform concentration distribution or at a non-uniform concentration distribution. For example, a formula may indicate the elements that are included in a compound, but an elemental ratio of the compound may vary. For example, AgInGaS₂ may indicate AgInₓGa₁₋ₓS₂ (wherein x is a real number between 0 to 1).

In embodiments, the quantum dot QD-C may have a single structure in which a concentration of each element included in the quantum dot QD-C is uniform, or the quantum dot QD-C may have a core-shell structure that includes a core QD-CO and a shell QD-S. For example, a material included in the core QD-CO may be different from a material included in the shell QD-S.

The shell QD-S of the quantum dot QD-C may serve as a protective layer that prevents chemical deformation of the core QD-CO to maintain semiconductor properties, and/or may serve as a charging layer that imparts electrophoretic properties to the quantum dot QD-C. The shell QD-S may be single-layered or multilayered. An interface between the core QD-CO and the shell QD-S may have a concentration gradient in which a concentration of an element that is present in the shell QD-S decreases toward the core QD-CO.

The shell QD-S of the quantum dot QD-C may include a metal oxide, a non-metal oxide, a semiconductor compound, or a combination thereof. Examples of a metal oxide or a non-metal oxide may include: a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound such as MgAl₂O₄, CoFe₂O₄, NiFe₂O₄, or CoMn₂O₄; and any combination thereof. Examples of a semiconductor compound may include, as described herein, a Group III-VI semiconductor compound, a Group II-VI semiconductor compound, a Group III-V semiconductor compound, a Group III-VI semiconductor compound, a Group I-III-VI semiconductor compound, a Group IV-VI semiconductor compound, and any combination thereof. For example, the semiconductor compound may include CdS, CdSe, CdTe, ZnS, ZnSe, ZnTe, ZnSeS, ZnTeS, GaAs, GaP, GaS, GaSe, AgGaS, AgGaS₂, GaSb, HgS, HgSe, HgTe, InAs, InP, InGaP, InSb, AlAs, AlP, AlSb, or any combination thereof.

The quantum dot QD-C may have a full width at half maximum (FWHM) of an emission spectrum equal to or less than about 45 nm. For example, the quantum dot QD-C may have a FWHM of an emission spectrum equal to or less than about 40 nm. For example, the quantum dot QD-C may have a FWHM of an emission spectrum equal to or less than about 30 nm. Color purity or color reproducibility may be improved in any of the above ranges. Light emitted by the quantum dot QD-C may be emitted in all directions, so that an optical viewing angle may be improved.

The form of the quantum dot QD-C is not particularly limited, and may be any form used in the related art. For example, the quantum dot QD-C may have a spherical shape, a pyramidal shape, a multi-arm shape, or a cubic shape, or the quantum dot QD-C may be in the form of a nano-tube, a nano-wire, a nano-fiber, a nano-plate, or the like.

An energy band gap of the quantum dot QD-C may be controlled by adjusting a particle size of the quantum dot QD-C or by adjusting an elemental ratio of a compound in the quantum dot QD-C, so that light of various wavelengths may be emitted by a light-emitting layer that includes the quantum dot QD-C. Accordingly, a light-emitting element that emits light of various wavelengths may be implemented by using quantum dots as described above (having different sizes of the quantum dot QD-C or different elemental ratios of compounds in the quantum dot QD-C). For example, the sizes of the quantum dot QD-C or the elemental ratio of compounds in the quantum dot QD-C may be selectively controlled to emit red light, green light, and/or blue light. In an embodiment, the quantum dots may be configured to emit white light through a combination of various color of light.

In the light-emitting element ED according to an embodiment, the electron transport region ETR may include a metal oxide IMO and an additive DI. In an embodiment, the electron transport layer ETL in the electron transport region ETR may include the metal oxide IMO and the additive DI.

According to an embodiment, the additive DI is represented by Chemical Formula 1:

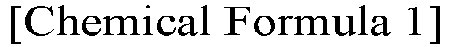

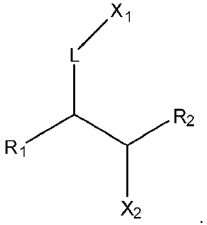

In Chemical Formula 1, X₁ and X₂ are each independently a hydroxy group, a substituted or unsubstituted amine group, or a cyano group; L is a direct linkage, or substituted or unsubstituted methylene group; and R₁ and R₂ are each independently a hydrogen atom, or a substituted or unsubstituted alkyl group having 1 to 8 carbon atoms (e.g. 1 to 6 carbon atoms).

In an embodiment, X₁ and X₂ may each independently be a hydroxy group, an unsubstituted amine group, or a cyano group. For example, X₁ and X₂ may be the same.

In an embodiment, Ri may be an unsubstituted methyl group, an unsubstituted ethyl group, an unsubstituted n-propyl group, an unsubstituted n-butyl group, an unsubstituted n-pentyl group, or an unsubstituted n-hexyl group. For example, Ri may be an unsubstituted methyl group.

In an embodiment, R₂ may be an unsubstituted methyl group, an unsubstituted ethyl group, or an unsubstituted n-propyl group. For example, R₂ may be an unsubstituted ethyl group.

In an embodiment, L may be an unsubstituted methylene group.

In an embodiment, the additive DI may include at least one compound selected from Compound Group 1:

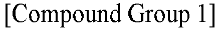

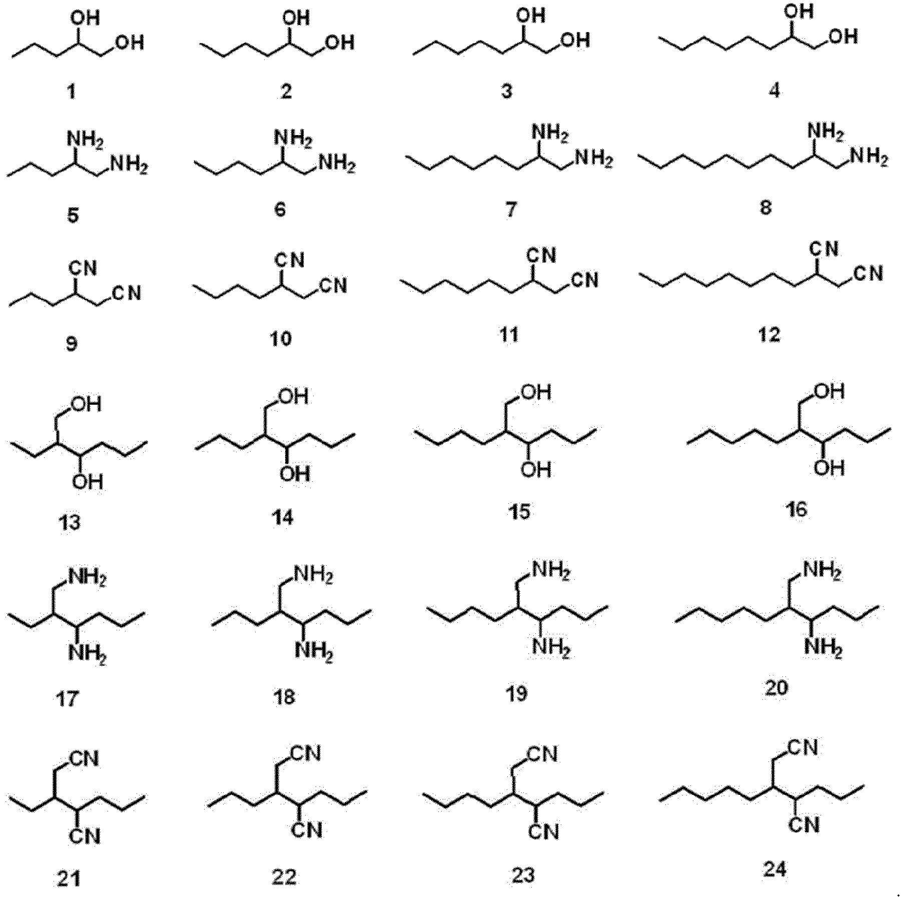

In an embodiment, the metal oxide IMO may include at least one of a first metal oxide represented by Chemical Formula 2 and a second metal oxide represented by Chemical Formula 3. In an embodiment, the metal oxide IMO may include the second metal oxide represented by Chemical Formula 3.

[Chemical Formula 2] MₐO_{b}

In Chemical Formula 2, M may be Ti, Zr, Sn, W, Ta, Ni, Mo, or Cu; and a and b may each independently be an integer from 1 to 5. For example, a and b may each be 1.

[Chemical Formula 3] Zn_{(1-c)}Q_{c}O

In Chemical Formula 3, Q may include at least one of Mg, Co, Ni, Zr, Mn, Sn, Y, and Al. In an embodiment, Q may be Mg. In Chemical Formula 3, c may be equal to or greater than 0 and less than 0.5. In an embodiment, c may be 0.12.

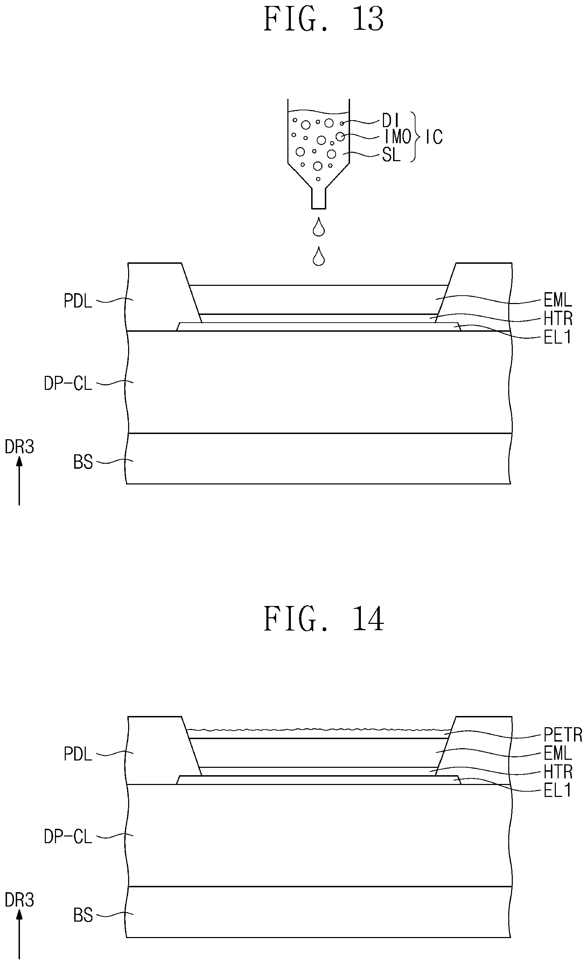

The light-emitting element ED according to an embodiment may improve an in-pixel uniformity (IPU) of the electron transport region ETR by including the metal oxide IMO and the additive DI. For example, the metal oxide IMO and the additive DI may be included in an ink composition IC (see FIG. 13) for forming the electron transport region ETR such that when the electron transport region ETR is formed, it has a substantially flat surface. When the electron transport region ETR is formed to have a substantially flat surface and in-pixel uniformity (IPU) is improved, a contact area between the electron transport region ETR and the light-emitting layer EML and a contact area between the electron transport region ETR and the second electrode EL2 each increase to improve electron transport efficiency, thereby improving luminous efficiency and lifespan of the light-emitting element ED.

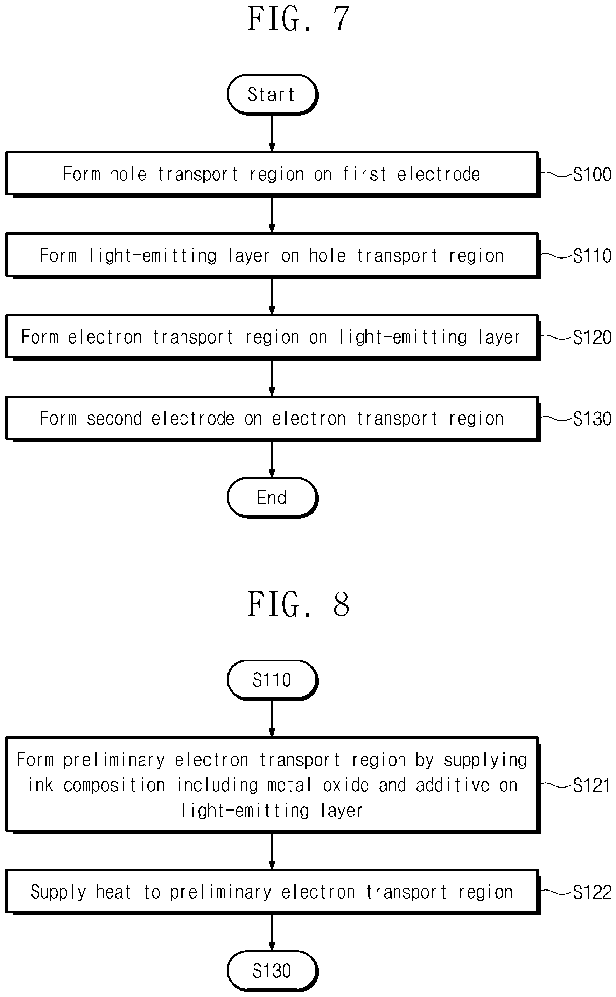

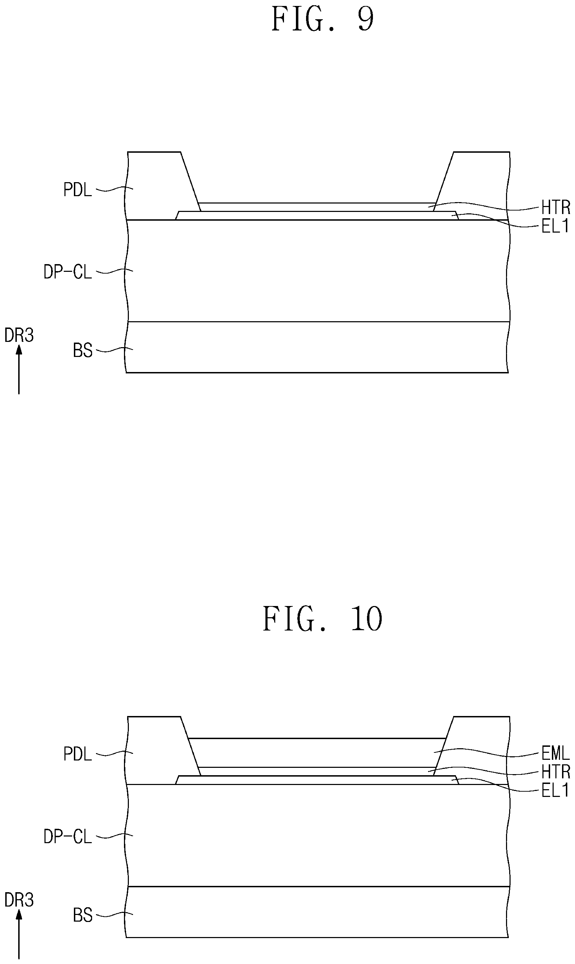

FIGS. 7 and 8 are each a flowchart illustrating a method for manufacturing a light-emitting element according to an embodiment. FIG. 8 is a flowchart that describes steps of forming an electron transport region according to an embodiment. FIGS. 9 to 16 are each a schematic cross-sectional view illustrating portions of a method for manufacturing a light-emitting element according to an embodiment.

Referring to FIG. 7, a method for manufacturing a light-emitting element according to an embodiment includes a step (S100) of forming a hole transport region on a first electrode, a step (S110) of forming a light-emitting layer on the hole transport region, a step (S120) of forming an electron transport region on the light-emitting layer, and a step (S130) of forming a second electrode on the electron transport region. The first electrode, the hole transport region, the light-emitting layer, the electron transport region, and the second electrode described in FIG. 7 may respectively be the same as described for the first electrode EL1, the hole transport region HTR, the light-emitting layer EML, the electron transport region ETR, and the second electrode EL2 as illustrated in FIG. 4.

Referring to FIGS. 7 and 9 together, the hole transport region HTR in the step (S100) of forming the hole transport region HTR may be formed using various methods such as a vacuum deposition method, a spin coating method, a cast method, a Langmuir-Blodgett (LB) method, an inkjet printing method, a laser printing method, or a laser induced thermal imaging (LITI) method. For example, the hole transport region HTR may be formed by a vacuum deposition method.

Referring to FIGS. 7 and 10 together, the light-emitting layer EML in the step (S 110) of forming the light-emitting layer EML may be formed using various methods such as a vacuum deposition method, a spin coating method, a cast method, a Langmuir-Blodgett (LB) method, an inkjet printing method, a laser printing method, or a laser induced thermal imaging (LITI) method. For example, the light-emitting layer EML may be formed by an inkjet printing method.

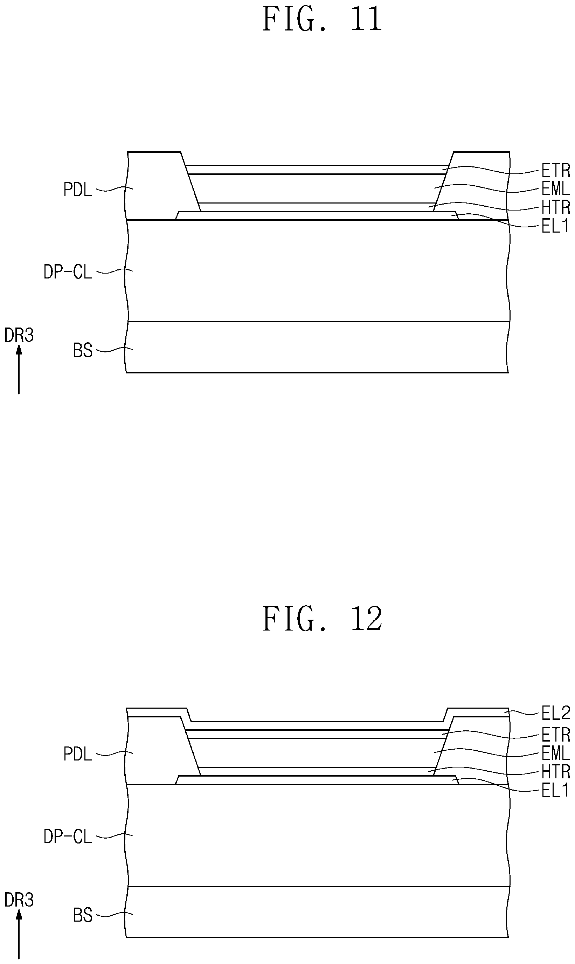

Referring to FIGS. 7 and 11 together, the electron transport region ETR in the step (S120) of forming the electron transport region ETR may be formed using various methods such as a vacuum deposition method, a spin coating method, a cast method, a Langmuir-Blodgett (LB) method, an inkjet printing method, a laser printing method, or a laser induced thermal imaging (LITI) method. For example, the electron transport region ETR may be formed by an inkjet printing method.

Referring to FIGS. 7 and 12 together, the second electrode EL2 in the step (S130) of forming the second electrode EL2 may be formed by physical vapor deposition (PVD), chemical vapor deposition (CVD), or atomic layer deposition (ALD). For example, the second electrode EL2 may be formed by physical vapor deposition (PVD).

Referring to FIGS. 7 and 8 together, the step (S120) of forming the electron transport region in the method for manufacturing a light-emitting element according to an embodiment may include a step (S121) of forming a preliminary electron transport region by supplying an ink composition including a metal oxide and an additive on the light-emitting layer, and a step (S122) of supplying heat to the preliminary electron transport region. The metal oxide and the additive described in the step (S121) of forming a preliminary electron transport region may respectively be the same as described for the metal oxide IMO and the additive DI as illustrated in FIG. 6.

Referring to FIGS. 8, 13, and 14 together, the ink composition IC in the step (S121) of forming a preliminary electron transport region PETR includes the metal oxide IMO and the additive DI. The ink composition IC may further include a solvent SL.

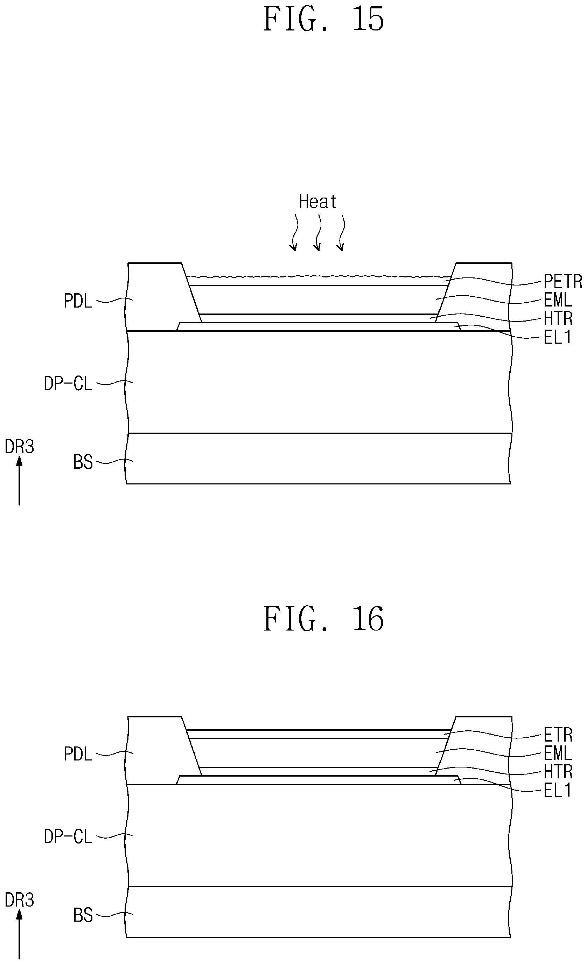

According to embodiments, the ink composition IC has a viscosity in a range of about 7.5 cP to about 8.0 cP at a temperature of about 25 °C. When the ink composition IC has a viscosity in a range of about 7.5 cP to about 8.0 cP at a temperature of about 25 °C, an in-pixel uniformity (IPU) of the electron transport region ETR (see FIG. 16) derived from the ink composition IC may be improved so that a contact area of the electron transport region ETR (see FIG. 16) and the light-emitting layer EML and a contact area between the electron transport region ETR (see FIG. 16) and the second electrode EL2 (see FIG. 16) increases to improve electron transport efficiency, thereby improving luminous efficiency and lifespan of the light-emitting element ED.

A volumetric amount of the additive DI may be in a range of about 7% to about 10% of a total volume of the ink composition IC. When the volumetric amount of the additive DI is in a range of about 7% to about 10% of a total volume of the ink composition IC, the ink composition IC may have a viscosity in a range of about 7.5 cP to about 8.0 cP at a temperature of about 25 °C.

Although not shown in the drawings, in an embodiment, the ink composition may further include an organic ligand that surrounds the metal oxide IMO. For example, the organic ligand may include a dicarboxylic acid, a tricarboxylic acid, a tetracarboxylic acid, or an imidazole-based compound. The organic ligand may surround the metal oxide IMO to improve stability, so that the metal oxide IMO readily disperses in the solvent SL.

According to an embodiment, the solvent SL may include a hydrophilic solvent or a hydrophobic solvent. The hydrophilic solvent may include at least one of diethylene glycol t-butyl ether (DGtBE), tripropylene glycol monobutyl ether (TPGBE), and triethylene glycol monoisopropyl ether (TGIPE). The hydrophobic solvent may include at least one of cyclohexylbenzene (CHB) and hexadecane. For example, the solvent SL may include diethylene glycol t-butyl ether (DGtBE). By dispersing the metal oxide IMO and the additive DI, the solvent SL may contribute to the uniform distribution of the metal oxide IMO and the additive DI in the preliminary electron transport region PETR in a deposition process for forming the preliminary electron transport region PETR (see FIGS. 13 and 14).

The preliminary electron transport region PETR may be formed using an inkjet printing method. The preliminary electron transport region PETR may be formed by filling the ink composition IC, which includes the solvent SL in which the metal oxide IMO and the additive DI are dispersed, in an inkjet printing head, and spraying the ink composition IC on the light-emitting layer EML. The ink composition IC has a viscosity in a range of about 7.5 cP to about 8.0 cP at a temperature of about 25 °C, and thus has excellent impact accuracy. When the ink composition IC has a viscosity less than about 7.5 cP at a temperature of about 25 °C, the electron transport region ETR may not be formed to have a substantially flat surface, so that the in-pixel uniformity (IPU) may not be improved. When the ink composition IC has a viscosity greater than about 8.0 cP at a temperature of about 25 °C, the ink composition IC may not readily discharge or may not be evenly sprayed so that the electron transport region ETR (see FIG. 16) is not formed to have a substantially flat surface, so that the in-pixel uniformity (IPU) may not be improved.

Referring to FIGS. 8, 15, and 16 together, when heat is supplied to the preliminary electron transport region PETR in the step (S122) of supplying heat, the solvent SL and the additive DI included in the preliminary electron transport region PETR may be at least partially vaporized to form the electron transport region ETR. For example, the solvent SL and the additive DI included in the preliminary electron transport region PETR may be at least partially vaporized by supplying heat at a temperature of about 140 °C to the preliminary electron transport region PETR for about 30 minutes so that the electron transport region ETR may be formed.

Hereinafter, an ink composition according to an embodiment will be described with reference to the Examples and the Comparative Examples. The Examples shown below are only provided to assist in understanding the disclosure, and the scope thereof is not limited thereto.

Table 1 shows a viscosity according to a volumetric amount of an additive with respect to a total volume of the ink composition according to the Examples and the Comparative Examples including metal oxides and different additives. The metal oxide in each of the Examples and the Comparative Examples was Zn_{0.88}Mg_{0.12}O, and a compound from Compound Group 1 was used as the additive. The viscosity was measured using a rotational viscometer at a temperature of 25 °C and a shear rate of 0.1 s⁻¹ to 1000 s⁻¹. A rotational viscometer DV-I Prime Brookfield rheometer was used as the measuring equipment, and the average of the results of more than five repeated measurements was calculated and presented.

**[Table 1]**

| | Metal oxide | Additive | Additive content (volume ratio with respect to ink composition [v/v %]) | Viscosity (cP) |
|---|---|---|---|---|
| Example 1 | Zn_{0.88}Mg_{0.12}O | Compound 1 | 10 | 7.6 |
| Example 2 | Zn_{0.88}Mg_{0.12}O | Compound 2 | 9 | 7.6 |
| Example 3 | Zn_{0.88}Mg_{0.12}O | Compound 3 | 8 | 7.8 |
| Example 4 | Zn_{0.88}Mg_{0.12}O | Compound 4 | 7 | 8.0 |
| Example 5 | Zn_{0.88}Mg_{0.12}O | Compound 5 | 10 | 7.5 |
| Example 6 | Zn_{0.88}Mg_{0.12}O | Compound 6 | 9 | 7.8 |
| Example 7 | Zn_{0.88}Mg_{0.12}O | Compound 7 | 8 | 7.7 |
| Example 8 | Zn_{0.88}Mg_{0.12}O | Compound 8 | 7 | 8.0 |
| Example 9 | Zn_{0.88}Mg_{0.12}O | Compound 9 | 10 | 7.6 |
| Example 10 | Zn_{0.88}Mg_{0.12}O | Compound 10 | 9 | 7.5 |
| Example 11 | Zn_{0.88}Mg_{0.12}O | Compound 11 | 8 | 7.9 |
| Example 12 | Zn_{0.88}Mg_{0.12}O | Compound 12 | 7 | 7.9 |
| Example 13 | Zn_{0.88}Mg_{0.12}O | Compound 13 | 10 | 7.8 |
| Example 14 | Zn_{0.88}Mg_{0.12}O | Compound 14 | 9 | 7.8 |
| Example 15 | Zn_{0.88}Mg_{0.12}O | Compound 15 | 8 | 7.7 |
| Example 16 | Zn_{0.88}Mg_{0.12}O | Compound 16 | 7 | 7.8 |
| Example 17 | Zn_{0.88}Mg_{0.12}O | Compound 17 | 10 | 8.0 |
| Example 18 | Zn_{0.88}Mg_{0.12}O | Compound 18 | 9 | 7.5 |
| Example 19 | Zn_{0.88}Mg_{0.12}O | Compound 19 | 8 | 7.8 |
| Example 20 | Zn_{0.88}Mg_{0.12}O | Compound 20 | 7 | 7.7 |
| Example 21 | Zn_{0.88}Mg_{0.12}O | Compound 21 | 10 | 7.9 |
| Example 22 | Zn_{0.88}Mg_{0.12}O | Compound 22 | 9 | 7.8 |
| Example 23 | Zn_{0.88}Mg_{0.12}O | Compound 23 | 8 | 7.8 |
| Example 24 | Zn_{0.88}Mg_{0.12}O | Compound 24 | 7 | 8.0 |
| Comparative Example 1 | Zn_{0.88}Mg_{0.12}O | - | - | 6.2 |
| Comparative Example 2 | Zn_{0.88}Mg_{0.12}O | Compound 13 | 5 | 6.1 |
| Comparative Example 3 | Zn_{0.88}Mg_{0.12}O | Compound 13 | 15 | 12.2 |
| Comparative Example 4 | Zn_{0.88}Mg_{0.12}O | Compound 13 | 20 | 15.5 |

Referring to Table 1, when the volumetric amount of the additive is in a range of about 7% to about 10% with respect to a total volume of the ink composition, the viscosity of the ink composition may be in a range of about 7.5 cP to 8.0 cP at a temperature of about 25 °C. Since the volumes of the additives in Examples 1 to 24 are in a range of 7% to about 10% with respect to a total volume of the ink composition, the viscosities of the ink compositions are in a range of about 7.5 cP to about 8.0 cP. A viscosity of Comparative Example 1 that does not include the additive is about 6.2 cP. Comparative Example 2 includes Compound 13 from Compound Group 1 as an additive, but the volumetric amount of the additive is about 5% with respect to a total volume of the ink composition, and thus has a viscosity of 6.1 cP. Comparative Examples 3 and 4 each include Compound 13 from Compound Group 1 as an additive, but respectively have a volumetric amount of the additive of about 15% and 20%, which are each greater than about 10%, with respect to a total volume of the ink composition, and thus respectively have viscosities of 12.2 cP and 15.5 cP. Table 2 below shows discharging characteristics and in-pixel uniformities (IPU) of films formed by discharging the ink compositions of Example 13 and Comparative Examples 1 to 4 in Table 1 above by an inkjet printing method. Evaluation criteria of the discharging characteristics were O if the impact accuracy is in a range of about -20 µm to about +20 µm, and X if it is not within the aforementioned range, and Dimatix Materials Printer DMP-2850 was used as the inkjet printer apparatus.

**[Table 2]**

| | Discharging characteristics | In-pixel uniformity (%) |
|---|---|---|
| Example 13 | O | 85 |
| Comparative Example 1 | O | 53 |
| Comparative Example 2 | O | 51 |
| Comparative Example 3 | O | 72 |
| Comparative Example 4 | X | - |

Referring to Table 2 above, Example 13 and Comparative Examples 1 to 3 each have impact accuracy of about -20 µm to about +20 µm to satisfy the discharging characteristics, but Comparative Example 4 does not satisfy the discharging characteristics as it did not discharge from the inkjet printer apparatus due to high viscosity. Example 13 satisfies a viscosity in a range of about 7.5 cP to about 8.0 cP at a temperature of about 25 °C to exhibit a superior in-pixel uniformity (IPU) as compared to Comparative Examples 1 to 3.

Hereinafter, a light-emitting element according to an embodiment will be described with reference to the Examples and the Comparative Examples. The Examples shown below are only provided to assist in understanding the disclosure, and the scope thereof is not limited thereto.

### [Example]

### 1. Manufacturing and Evaluation of Light-emitting Element

### (1) Manufacturing of Light-emitting Element

A light-emitting element according to an embodiment formed from an ink composition according to an embodiment in an electron transport region was manufactured according to a method described below.

### (Manufacturing of Light-emitting Element)

After a substrate on which ITO had been deposited as an anode was cut at a size of about 50 mm x about 50 mm x about 0.5 mm, and was ultrasonically cleaned with isopropyl alcohol and pure water for about 5 minutes each, the ITO substrate was cleaned by irradiating ultraviolet light for about 30 minutes and exposure to ozone, and was installed in a vacuum deposition apparatus.

A hole injection layer HIL of about 1140 Å was formed on the ITO substrate by spin-coating, and a hole transport layer HTL having a thickness of 400 Å was formed.

A light-emitting layer was formed by spin-coating, on the hole transport layer, quantum dots having a structure of InP/ZnSe/ZnS so as to have a thickness of 200 Å, and an electron transport layer having a thickness of 480 Å was formed by spin-coating ink compositions according to the Examples on the light-emitting layer. A light-emitting element was manufactured by depositing AgMg of 200 Å on the electron transport layer to form a cathode.

### (2) Evaluation of Characteristics of Light-emitting Element

### (Evaluation of Characteristics of Light-emitting Element)

Luminous efficiency (Cd/A, @1280nit) and element lifespan h (@T90) of the light-emitting elements of Example 13 and the Comparative Examples described above were evaluated. Table 3 below shows evaluation results of the light-emitting elements of Example 13 and the Comparative Examples. In order to evaluate characteristics of the light-emitting elements manufactured in Example 13 and the Comparative Examples, luminous efficiency (Cd/A) was measured in 1280 nit, and an absolute time taken for luminance to reach 90% of initial luminance was measured as the element lifespan (@T90).

**[Table 3]**

| | Luminous efficiency, Cd/A (@1280nit) | Element lifespan, hours (@T90) |
|---|---|---|
| Example 13 | 72 | 350 |
| Comparative Example 1 | 60 | 200 |
| Comparative Example 2 | 61 | 210 |
| Comparative Example 3 | 59 | 150 |
| Comparative Example 4 | - | - |

Referring to Table 3 above, the light-emitting element including the electron transport region derived from the ink composition according to an embodiment has superior efficiency and lifespan. When the viscosity of the ink composition is in a range of about 7.5 cP to about 8.0 cP at a temperature of about 25 °C, the in-pixel uniformity (IPU) of the electron transport region derived from the ink composition is improved so that a contact area between the electron transport region and the light-emitting layer and a contact area between the electron transport region and the second electrode each increase to improve electron transport efficiency, thereby improving luminous efficiency and lifespan of the light-emitting element.

An ink composition according to an embodiment may be included in an electron transport region of a light-emitting element to improve an in-pixel uniformity, and to contribute to the improvement of luminous efficiency and lifespan of the light-emitting element.

The light-emitting element according to an embodiment may show characteristics of high efficiency and long lifespan.

A method for manufacturing a light-emitting element according to an embodiment may supply a method for manufacturing a light-emitting exhibiting high efficiency and a long lifespan.

Embodiments have been disclosed herein, and although terms are employed, they are used and are to be interpreted in a generic and descriptive sense only and not for the purposes of limitation. In some instances, as would be apparent to one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the claims.

## Claims

1. An ink composition comprising:
a metal oxide; and
an additive represented by Chemical Formula 1, wherein
the ink composition has a viscosity in a range of about 7.5 cP to about 8.0 cP at a temperature of about 25 °C: 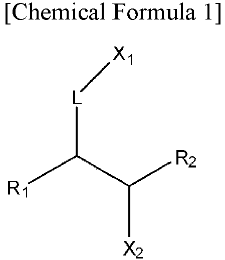 wherein in Chemical Formula 1,
X₁ and X₂ are each independently a hydroxy group, a substituted or unsubstituted amine group, or a cyano group,
L is a direct linkage or substituted or unsubstituted methylene group, and
R₁ and R₂ are each independently a hydrogen atom, or a substituted or unsubstituted alkyl group having 1 to 8 carbon atoms.

2. The ink composition of claim 1, wherein in Chemical Formula 1, Ri is an unsubstituted methyl group, an unsubstituted ethyl group, an unsubstituted n-propyl group, an unsubstituted n-butyl group, an unsubstituted n-pentyl group, or an unsubstituted n-hexyl group.

3. The ink composition of claim 1 or claim 2, wherein in Chemical Formula 1, R₂ is an unsubstituted methyl group, an unsubstituted ethyl group, or an unsubstituted n-propyl group.

4. The ink composition of any one of claims 1 to 3, wherein in Chemical Formula 1, L is an unsubstituted methylene group.

5. The ink composition of any one of claims 1 to 4, wherein a volumetric amount of the additive is in a range of about 7% to about 10% of a total volume of the ink composition.

6. The ink composition of any one of claims 1 to 5, further comprising:
a solvent that disperses the metal oxide and the additive.

7. The ink composition of any one of claims 1 to 6, further comprising:
an organic ligand surrounding the metal oxide.

8. The ink composition of any one of claims 1 to 7, wherein the additive comprises at least one compound selected from Compound Group 1:

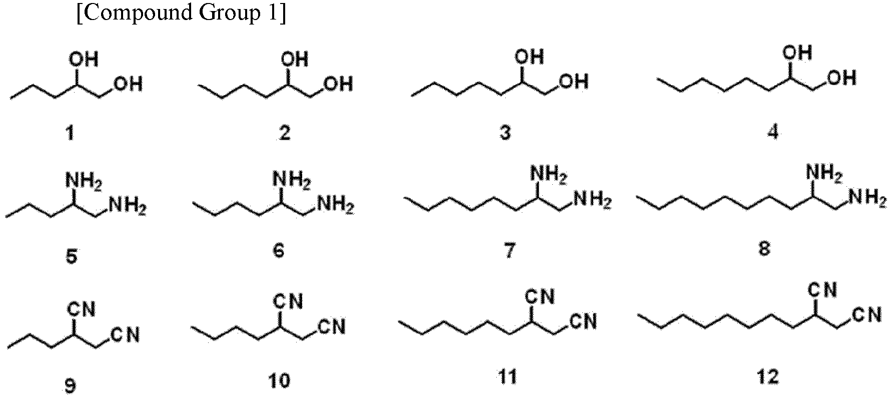

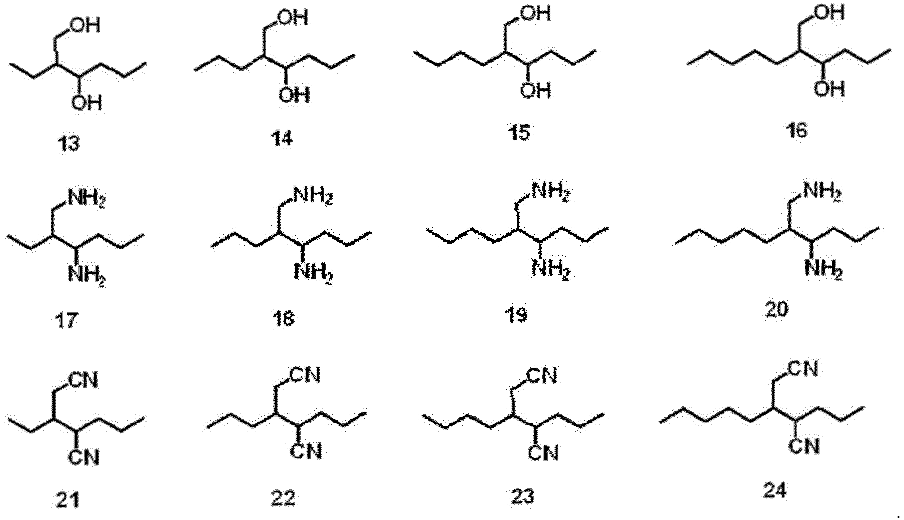

9. The ink composition of any one of claims 1 to 8, wherein the metal oxide comprises at least one of a first metal oxide represented by Chemical Formula 2 and a second metal oxide represented by Chemical Formula 3:
[Chemical Formula 2] MₐO_{b}
wherein in Chemical Formula 2,
M is Ti, Zr, Sn, W, Ta, Ni, Mo, or Cu, and
a and b are each independently an integer from 1 to 5,
[Chemical Formula 3] Zn_{(1-c)}Q_{c}O
wherein in Chemical Formula 3,
Q includes at least one of Mg, Co, Ni, Zr, Mn, Sn, Y, and Al, and
c is equal to or greater than 0 and less than 0.5.

10. The ink composition of claim 9, wherein
the metal oxide comprises the second metal oxide represented by Chemical Formula 3, and
in Chemical Formula 3, Q is Mg, and c is 0.12.

11. A light-emitting element comprising:
a first electrode;
a first functional layer disposed on the first electrode;
a light-emitting layer disposed on the first functional layer;
a second functional layer disposed on the light-emitting layer; and
a second electrode disposed on the second functional layer, wherein
the first or second functional layers include an additive represented by Chemical Formula 1: 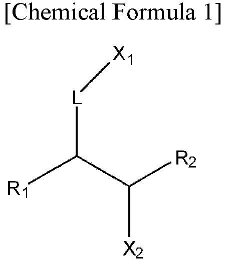 wherein in Chemical Formula 1,
X₁ and X₂ are each independently a hydroxy group, a substituted or unsubstituted amine group, or a cyano group,
L is a direct linkage or substituted or unsubstituted methylene group, and
Ri and R₂ are each independently a hydrogen atom, or a substituted or unsubstituted alkyl group having 1 to 8 carbon atoms.

12. The light-emitting element of claim 11, wherein the additive comprises at least one compound selected from Compound Group 1:

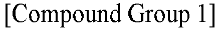

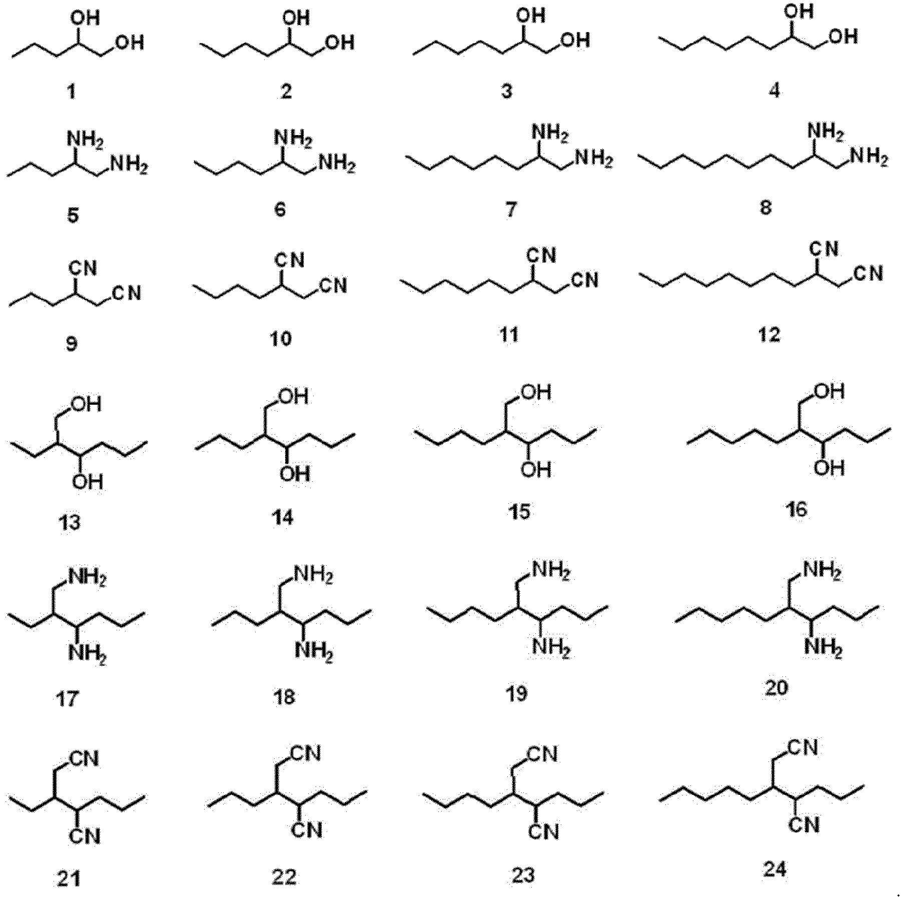

13. The light-emitting element of claim 11 or claim 12, wherein
the first functional layer comprises a hole transport region,
the second functional layer comprises an electron transport region, and
the electron transport region comprises the additive.

14. The light-emitting element of claim 11 or claim 12, wherein
the first functional layer comprises an electron transport region,
the second functional layer comprises a hole transport region, and
the electron transport region comprises the additive.

15. The light-emitting element of any one of claims 11 to 13, wherein
the second functional layer comprises:
an electron transport layer disposed on the light-emitting layer; and
an electron injection layer disposed between the electron transport layer and the second electrode, and
the electron transport layer comprises the additive.
